# EUROPEAN PATENT SPECIFICATION

(11) **EP 3 041 329 B1**
(45) Date of publication and mention of the grant of the patent: **29.11.2017**
(21) Application number: 14200574.3
(22) Date of filing: 30.12.2014
(51) Int. Cl.: H05K 7/14

(54) **Cable management arm**
Kabelmanagementarm
Bras de gestion de câbles

(43) Date of publication of application: 06.07.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Chou, Chi-Chih, Kaohsiung City (TW); Wu, Chi-Wei, Kaohsiung City (TW); Wang, Chun-Chiang, Kaohsiung City (TW)
(74) Representative: Viering, Jentschura & Partner mbB Patent- und Rechtsanwälte

(56) References cited:
- WO-A1-2010/126461
- US-A1- 2011 180 297
- US-B2- 7 554 819

## Description

### Field of the Invention

The present invention relates to a cable management arm. More particularly, the present invention relates to a cable management arm which is applicable not only to a server chassis, but also to at least two different areas of the chassis.

### Background of the Invention

With the rapid development of information technology and the telecommunication industry, demand for server systems is increasing. As is well known in the art, a server system includes a server for storing massive amounts of electronic information, and the chassis of the server typically has two opposite lateral sides respectively mounted to the posts of a rack via two slide rail assemblies and is designed to protect the electronic devices or parts of the server, wherein the electronic devices or parts generally have cables essential to normal operation of the server. It is common practice, therefore, to equip a server system with a cable management arm (CMA) for carrying such cables and thereby satisfying the need for cable management.

For instance, the specification of US Patent No. 7,554, 819 B2 discloses a cable management arm applicable to a general server chassis. The cable management arm includes a frame (1), a support rail (2), two sliding members (3, 4), two connectors (5, 6), and an insertion socket (7). The frame (1) of the cable management arm includes front and rear arms (11, 12) for holding the cables of a server (e.g., with the cables passing through and placed in the cable holders (15) on each arm).

It is sometimes required, however, that the chassis of a large server have a two-tier structure and be divided into different working areas. In that case, cables in the upper tier of the chassis and those in the lower tier cannot be properly arranged without a specially designed cable management arm. It is therefore important to develop a cable management arm which can hold cables extending from different areas of a chassis and which can also be rapidly mounted and detached.

US 7,544,819 B2 discloses a cable management arm comprising one cable management mechanism and one supporting mechanism. The cable management mechanism comprises a first arm member and a second arm member which are connected to an outer rail by connecting devices. Both arm members are supported by one support rail. Further the supporting mechanism includes a movable member which is connected to the supporting rail. The support rail is slidably guided in two outer rails.

WO 2010/126461 A1 discloses a cable management arm according to the preamble to claim 1. The cable management arm comprises a first lower articulated cable management mechanism and a second, upper articulated cable management mechanism. Both cable management mechanisms include a first arm member and a second arm member. The first arm members are movably connected to first connecting devices and the second arm members are movably connected to second connecting devices. The connecting devices connect the arm members with the rails of the rack slides.

### Summary of the Invention

The present invention relates to a cable management arm according to claim 1. The cable management arm can be applied to at least two different areas of a server chassis.

According to one aspect of the present invention, a cable management arm is provided for use with a chassis which includes an upper-tier area and a lower-tier area and whose two opposite lateral sides are mounted to a rack via a first slide rail assembly and a second slide rail assembly respectively. Each of the slide rail assemblies includes a fixed rail and a movable rail longitudinally displaceable with respect to the fixed rail. The two opposite lateral sides of the chassis are mounted to the movable rails of the slide rail assemblies respectively. The cable management arm includes a first cable management mechanism, a first supporting mechanism, a second cable management mechanism, and a second supporting mechanism. The first cable management mechanism includes: a first arm member; a second arm member movably connected to the first arm member, wherein the first arm member and the second arm member of the first cable management mechanism generally correspond in position to the upper-tier area of the chassis; a first connecting device movably connected to the first arm member, the first connecting device including a first connecting section, a second connecting section, and a passage at the first connecting section, the first connecting device being releasably mounted to the fixed rail of the first slide rail assembly; a supporting bracket connected to the second connecting section; and a second connecting device movably connected to the second arm member, the second connecting device being releasably mounted to the chassis. The first supporting mechanism includes: a first supporting rail for supporting one of the first arm member and the second arm member of the first cable management mechanism; a second supporting rail telescopically connected to the first supporting rail; a movable member connected to the first supporting rail, the movable member being movably mounted to the passage of the first connecting device of the first cable management mechanism; and a fastener connected to the second supporting rail. The second cable management mechanism includes: a first arm member; a second arm member movably connected to the first arm member, wherein the first arm member and the second arm member of the second cable management mechanism generally correspond in position to the lower-tier area of the chassis; a first connecting device movably connected to the first arm member, the first connecting device including an extension, the first connecting device being releasably mounted to the fixed rail of the second slide rail assembly; a supporting bracket connected to the extension, the supporting bracket being releasably connected to the fastener of the first supporting mechanism; and a second connecting device movably connected to the second arm member, the second connecting device being releasably mounted to the chassis. The second supporting mechanism includes: a first supporting rail for supporting one of the first arm member and the second arm member of the second cable management mechanism; a second supporting rail telescopically connected to the first supporting rail; a movable member connected to the first supporting rail, the movable member being movably mounted to the first connecting device of the second cable management mechanism; and a fastener connected to the second supporting rail, the fastener being releasably mounted to the supporting bracket of the first cable management mechanism.

One of the advantageous features of implementing the present invention is that the cable management arm can be applied to at least two different areas of a server chassis to arrange cables connected to or extending from the different areas of the chassis.

### Brief Description of the Drawings

The invention as well as a preferred mode of use and the advantages thereof will be best understood by referring to the following detailed description of some illustrative embodiments in conjunction with the accompanying drawings, in which:
FIG. 1 schematically shows how the cable management arm in an embodiment of the present invention is applied to different areas of a chassis;
FIG. 2 is a schematic exploded view showing how the cable management arm in an embodiment of the present invention is applied to a chassis and two slide rail assemblies;
FIG. 3 is an exploded view of the arm members of the first cable management mechanism of the cable management arm in an embodiment of the present invention;
FIG. 4 is a perspective view of the first cable management mechanism of the cable management arm in an embodiment of the present invention;
FIG. 5 is an exploded view of the first connecting device and the supporting bracket of the first cable management mechanism of the cable management arm in an embodiment of the present invention;
FIG. 5A is a partial view of the first cable management mechanism in FIG. 5, showing in particular the supporting bracket of the first cable management mechanism;
FIG. 6 is a schematic exploded view of the second connecting device of the first cable management mechanism of the cable management arm in an embodiment of the present invention;
FIG. 7 is an exploded view of the first supporting mechanism of the cable management arm in an embodiment of the present invention;
FIG. 8 is a perspective view of the first supporting mechanism of the cable management arm in an embodiment of the present invention;
FIG. 9 is a schematic exploded view of the first cable management mechanism and the first supporting mechanism of the cable management arm in an embodiment of the present invention, wherein the second connecting device of the first cable management mechanism can be mounted to the first connecting base in a releasable manner, and wherein the first connecting device of the first cable management mechanism and the movable member of the first supporting mechanism can be jointly mounted to the first slide rail assembly in a releasable manner;
FIG. 10 is a partial schematic drawing showing how the first connecting device of the first cable management mechanism of the cable management arm in an embodiment of the present invention and the movable member of the first supporting mechanism can be jointly mounted to the first slide rail assembly in a releasable manner;
FIG. 11 is a partial perspective view showing how the first connecting device of the first cable management mechanism of the cable management arm in an embodiment of the present invention and the movable member of the first supporting mechanism are jointly mounted to the first slide rail assembly;
FIG. 12 is an exploded view of the second connecting device of the first cable management mechanism of the cable management arm in an embodiment of the present invention and the first connecting base;
FIG. 13 is an assembled perspective view of the second connecting device of the first cable management mechanism of the cable management arm in an embodiment of the present invention and the first connecting base;
FIG. 14 is an assembled perspective view showing how the second connecting device of the first cable management mechanism of the cable management arm in an embodiment of the present invention is mounted to the first connecting base, and how the first connecting device of the first cable management mechanism and the movable member of the first supporting mechanism are jointly mounted to the first slide rail assembly;
FIG. 15 is a perspective view of the second cable management mechanism of the cable management arm in an embodiment of the present invention;
FIG. 16 is a perspective view of the second supporting mechanism of the cable management arm in an embodiment of the present invention;
FIG. 17 is a schematic perspective view showing how the cable management arm in an embodiment of the present invention is pulled out along with a chassis and hence enters an extended state;
FIG. 18A shows how the first connecting device of a cable management mechanism of the cable management arm in an embodiment of the present invention is assembled to the fixed rail of a slide rail assembly;
FIG. 18B shows how the first connecting device in FIG. 18A is detached from the fixed rail of the slide rail assembly;
FIG. 18C further shows how the first connecting device in FIG. 18A is detached from the fixed rail of the slide rail assembly;
FIG. 19A shows how the second connecting device of a cable management mechanism of the cable management arm in an embodiment of the present invention is assembled to a connecting base;
FIG. 19B shows how the second connecting device in FIG. 19A is detached from the connecting base;
FIG. 19C further shows how the second connecting device in FIG. 19A is detached from the connecting base;
FIG. 20A shows how the fastener of a supporting mechanism of the cable management arm in an embodiment of the present invention is assembled to the supporting bracket of a cable management mechanism;
FIG. 20B shows how the fastener in FIG. 20A is detached from the supporting bracket of the cable management mechanism;
FIG. 20C further shows how the fastener in FIG. 20A is detached from the supporting bracket of the cable management mechanism;
FIG. 21 schematically shows how the cable management arm in an embodiment of the present invention is mounted to a rack and a chassis, wherein the cable management arm is in a folded state;
FIG. 22 schematically shows how the cable management arm in an embodiment of the present invention is mounted to a rack and a chassis, wherein the cable management arm is gradually extended from a folded state to an extended state; and
FIG. 23 schematically shows how the cable management arm in an embodiment of the present invention is mounted to a rack and a chassis, wherein the cable management arm is in an extended state.

### Detailed Description of the Invention

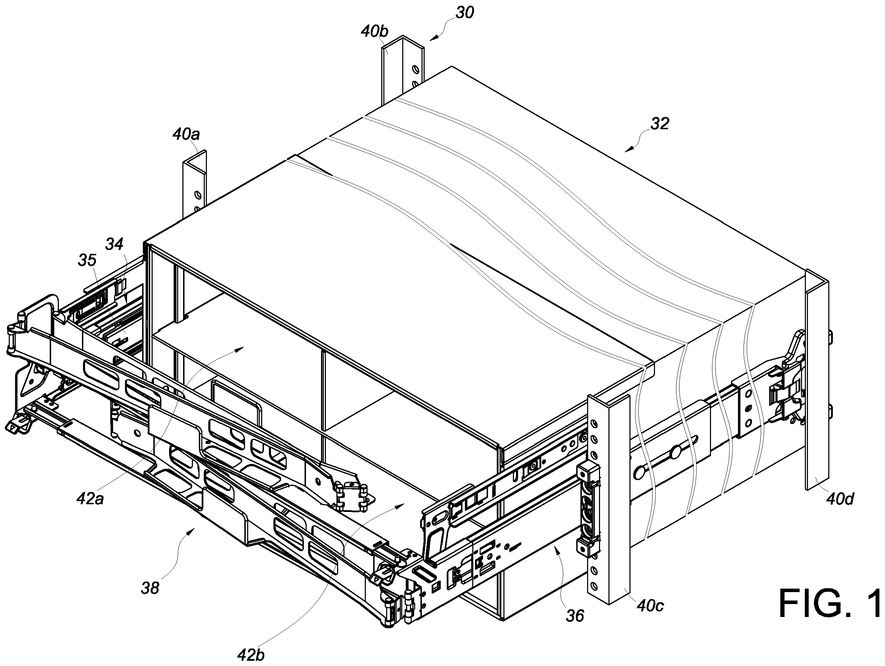

Referring to FIG. 1, an embodiment of the present invention includes a rack 30, a chassis 32, a first slide rail assembly 34, a second slide rail assembly 36, and a cable management arm 38. The rack 30 has a plurality of supporting posts 40a, 40b, 40c, and 40d. The chassis 32 includes an upper-tier area 42a and a lower-tier area 42b. The first slide rail assembly 34 is mounted to a lateral side of the chassis 32 and between the supporting posts 40a and 40b of the rack 30 (e.g., this lateral side of the chassis 32 being mounted to a movable rail 35 of the first slide rail assembly 34). The second slide rail assembly 36 is mounted to an other lateral side of the chassis 32 and between the supporting posts 40c and 40d of the rack 30 (e.g., this lateral side of the chassis 32 being mounted to a movable rail (not shown) of the second slide rail assembly 36). Thus, the chassis 32 can be easily pulled out of and pushed back into the rack 30 via the first and the second slide rail assemblies 34 and 36. The cable management arm 38 is connected between the first slide rail assembly 34 and the second slide rail assembly 36 and is configured for arranging cables connected to or extending from a rear side of the chassis 32.

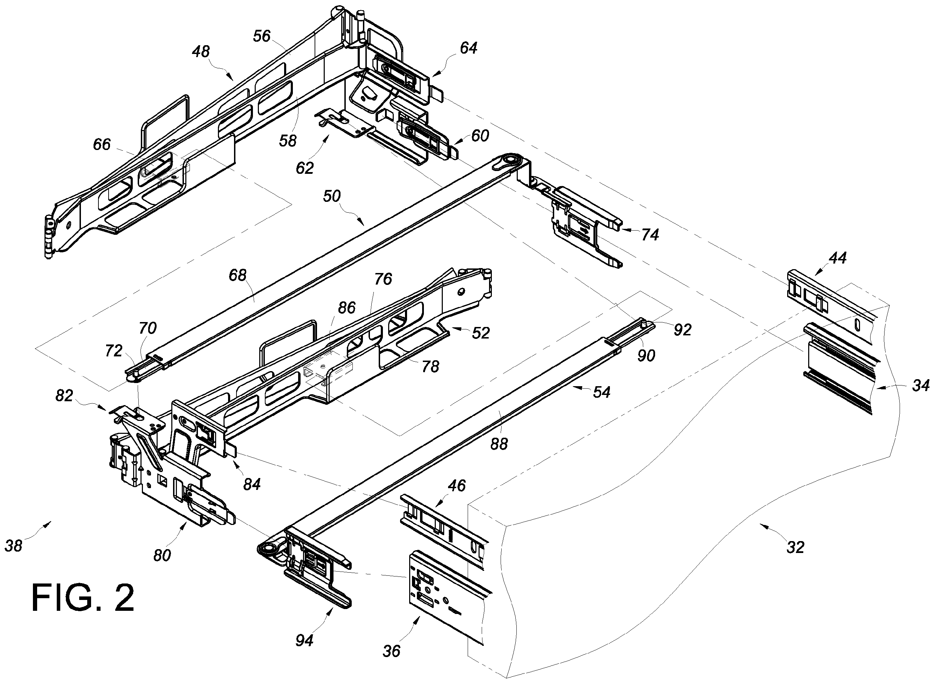

As shown in FIG. 2, a first connecting base 44 is fixedly mounted to the lateral side of the chassis 32 which is adjacent to the first slide rail assembly 34, and a second connecting base 46 is fixedly mounted to the opposite lateral side of the chassis 32 which is adjacent to the second slide rail assembly 36. The cable management arm 38 includes a first cable management mechanism 48, a first supporting mechanism 50, a second cable management mechanism 52, and a second supporting mechanism 54. The first cable management mechanism 48 includes a first arm member 56; a second arm member 58 connected to the first arm member 56; a first connecting device 60 and a supporting bracket 62, both connected to one end of the first arm member 56; a second connecting device 64 connected to the second arm member 58; and a slider 66 connected to an arm portion of the first arm member 56. The second connecting device 64 can be connected to the first connecting base 44. The first supporting mechanism 50 includes a first supporting rail 68, a second supporting rail 70 telescopically connected to the first supporting rail 68, a fastener 72 connected to the second supporting rail 70 (e.g., the fastener 72 being connected to the second supporting rail 70 at a position adjacent to an end portion thereof), and a movable member 74 connected to the first supporting rail 68. The slider 66 of the first cable management mechanism 48 is movably connected to, and can be displaced along, the first supporting rail 68 of the first supporting mechanism 50. The first supporting rail 68 of the first supporting mechanism 50 serves to support one of the first arm member 56 and the second arm member 58 of the first cable management mechanism 48 (e.g., the first arm member 56 of the first cable management mechanism 48). It is feasible to first connect the movable member 74 to the first connecting device 60 of the first cable management mechanism 48 and then connect them jointly to the first slide rail assembly 34. The second cable management mechanism 52 includes a first arm member 76; a second arm member 78 connected to the first arm member 76; a first connecting device 80 and a supporting bracket 82, both connected to one end of the first arm member 76; a second connecting device 84 connected to the second arm member 78; and a slider 86 connected to an arm portion of the first arm member 76. The second connecting device 84 can be connected to the second connecting base 46. The second supporting mechanism 54 includes a first supporting rail 88, a second supporting rail 90 telescopically connected to the first supporting rail 88, a fastener 92 connected to the second supporting rail 90 (e.g., the fastener 92 being connected to the second supporting rail 90 at a position adjacent to an end portion thereof), and a movable member 94 connected to the first supporting rail 88. The slider 86 of the second cable management mechanism 52 is movably connected to the first supporting rail 88 of the second supporting mechanism 54. The first supporting rail 88 of the second supporting mechanism 54 serves to support one of the first arm member 76 and the second arm member 78 of the second cable management mechanism 52 (e.g., the first arm member 76 of the second cable management mechanism 52). It is feasible to connect the movable member 94 to the first connecting device 80 of the second cable management mechanism 52 before connecting them jointly to the second slide rail assembly 36. The supporting bracket 82 of the second cable management mechanism 52 and the fastener 72 of the first supporting mechanism 50 are assembled together in a releasable manner, and so are the fastener 92 of the second supporting mechanism 54 and the supporting bracket 62 of the first cable management mechanism 48. Thus, the first cable management mechanism 48 and the first supporting mechanism 50 are releasably assembled with the second cable management mechanism 52 and the second supporting mechanism 54. In a preferred embodiment, the first cable management mechanism 48 and the second cable management mechanism 52 are of substantially the same structure; their difference consists generally in that the supporting bracket 62 of the first cable management mechanism 48 is adjacent to and below the first connecting device 60 of the first cable management mechanism 48 whereas the supporting bracket 82 of the second cable management mechanism 52 is adjacent to and above the first connecting device 80 of the second cable management mechanism 52. Apart from that, the first connecting device 60 of the first cable management mechanism 48 is connected to the movable member 74 of the first supporting mechanism 50 and then releasably mounted to the first slide rail assembly 34 in generally the same way as the first connecting device 80 of the second cable management mechanism 52 is connected to the movable member 94 of the second supporting mechanism 54 and then releasably mounted to the second slide rail assembly 36, the second connecting device 64 of the first cable management mechanism 48 is releasably mounted to the first connecting base 44 in generally the same way as the second connecting device 84 of the second cable management mechanism 52 is releasably mounted to the second connecting base 46, and the fastener 92 of the second supporting mechanism 54 is releasably mounted to the supporting bracket 62 of the first cable management mechanism 48 in generally the same way as the fastener 72 of the first supporting mechanism 50 is releasably mounted to the supporting bracket 82 of the second cable management mechanism 52.

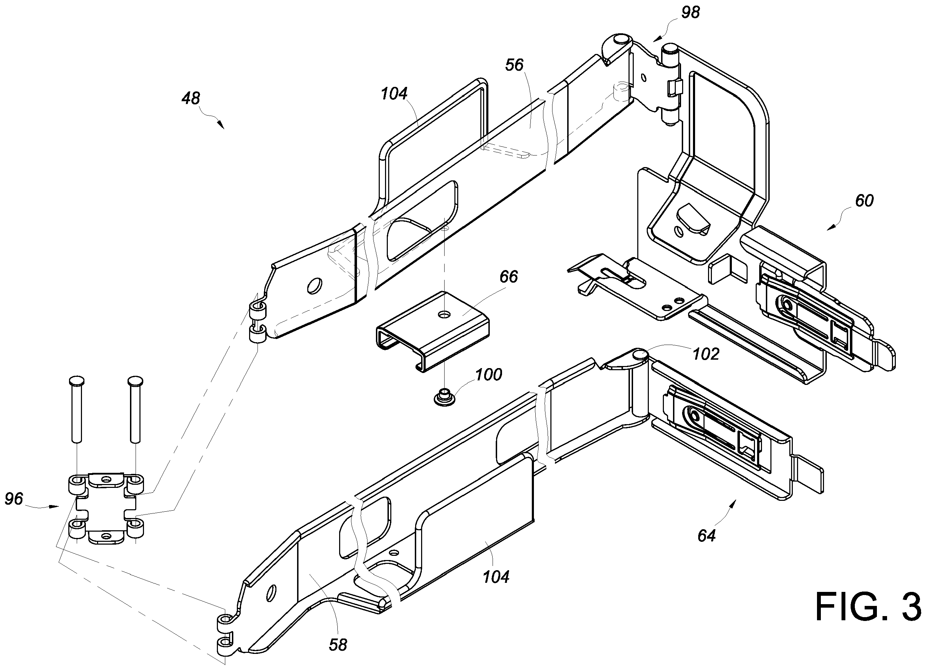

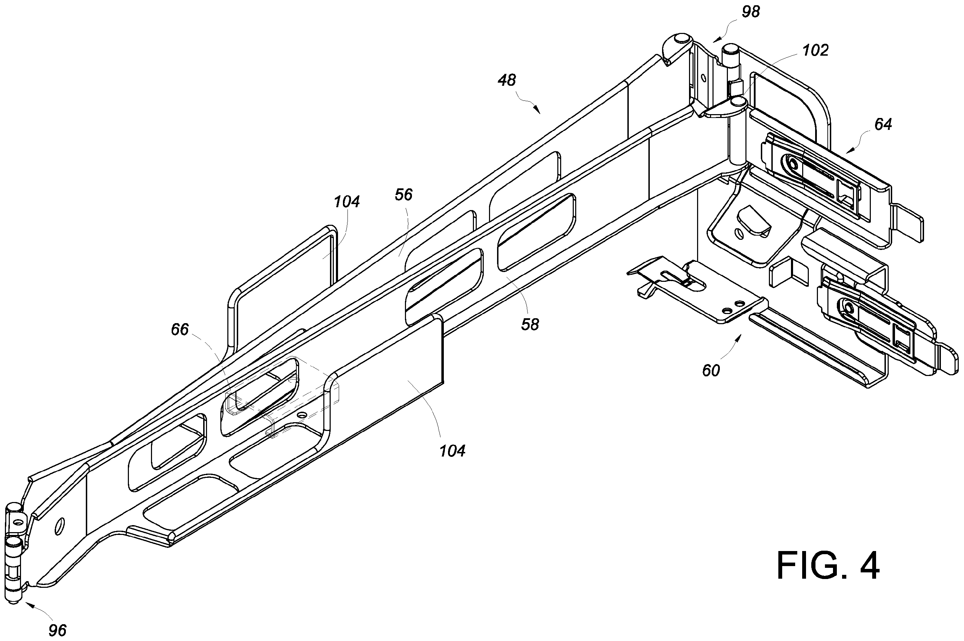

FIG. 3 and FIG. 4 are an exploded view and an assembled perspective view of the first cable management mechanism 48 respectively. In this embodiment, a first hinge structure 96 is connected between the first arm member 56 and the second arm member 58 so that the first arm member 56 and the second arm member 58 can be brought close to each other and thus enter a folded state (or be extended from the folded state to a generally V-shaped extended state). Also, a second hinge structure 98 is connected between the first arm member 56 and the first connecting device 60, allowing the first connecting device 60 to rotate with respect to the first arm member 56. In addition, a first pivot member 100 connects the slider 66 to the first arm member 56 to enable rotation of the first arm member 56 relative to the slider 66, and a second pivot member 102 connects the second connecting device 64 to the second arm member 58 to enable rotation of the second connecting device 64 relative to the second arm member 58. Each of the arm members 56 and 58 has a cable supporting feature 104, such as a U-shaped structure, to facilitate storage and management of cables.

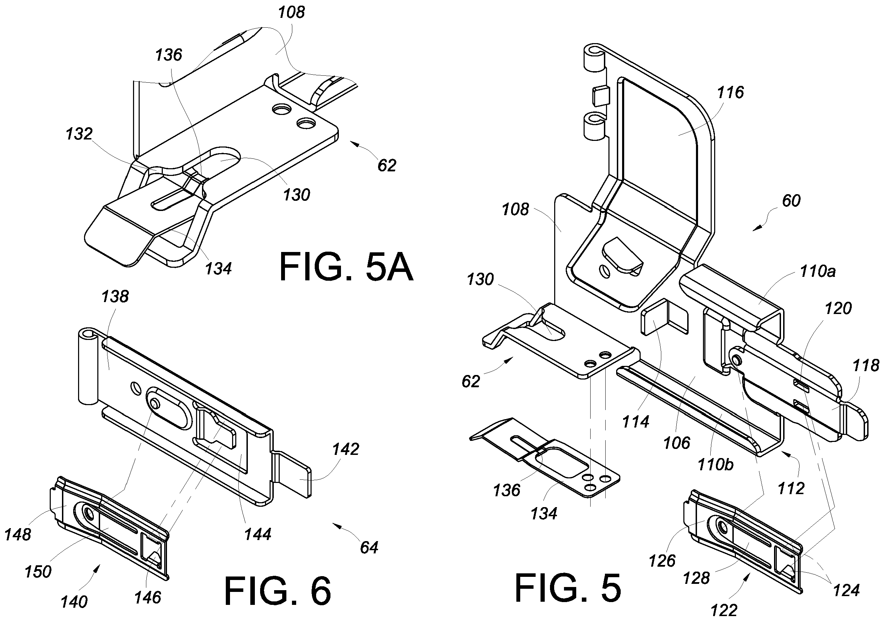

Referring to FIG. 5, the first connecting device 60 includes a first connecting section 106; a second connecting section 108 extending longitudinally from the first connecting section 106; an upper wall 110a and a lower wall 110b extending respectively from an upper edge and a lower edge of the first connecting section 106 such that a passage 112 is defined between the upper wall 110a, the lower wall 110b, and the first connecting section 106; a stop portion 114 provided between the first connecting section 106 and the second connecting section 108; a third connecting section 116 extending upward from the second connecting section 108 and higher than the upper wall 110a, wherein the third connecting section 116 is movably connected to the first arm member 56 of the first cable management mechanism 48 via the second hinge structure 98 (as shown in FIG. 3); an inserting portion 118 extending from the first connecting section 106 and partially beyond the passage 112, wherein the part of the inserting portion 118 that is outside the passage 112 has at least one engaging hole 120; and an engaging member 122 elastically connected to the inserting portion 118, wherein the engaging member 122 includes at least one engaging portion 124 corresponding to the at least one engaging hole 120 of the inserting portion 118, a releasing portion 126, and an elastic portion 128 provided between the at least one engaging portion 124 and the releasing portion 126. More specifically, the engaging member 122 is elastically connected to the inserting portion 118 via the elastic portion 128, and the at least one engaging portion 124 is engaged in the at least one engaging hole 120 of the inserting portion 118 in response to the elastic force provided by the elastic portion 128. Referring also to FIG. 5A, the supporting bracket 62 of the first cable management mechanism 48 is connected to and extends transversely from the second connecting section 108. In an embodiment, the supporting bracket 62 has a positioning hole 130 and a mounting hole 132 in communication with the positioning hole 130. Moreover, a positioning member 134 is elastically connected to the supporting bracket 62. The positioning member 134, which can be viewed as a part of the supporting bracket 62, has a blocking portion 136 corresponding to a position between the positioning hole 130 and the mounting hole 132.

As shown in FIG. 6, the second connecting device 64 includes a connecting member 138 and an engaging member 140 elastically connected to the connecting member 138. The connecting member 138 has an inserting portion 142 and an engaging hole 144. The engaging member 140 has generally the same configuration as the engaging member 122 and includes at least one engaging portion 146 corresponding to the engaging hole 144 of the connecting member 138, a releasing portion 148, and an elastic portion 150 provided between the engaging portion 146 and the releasing portion 148.

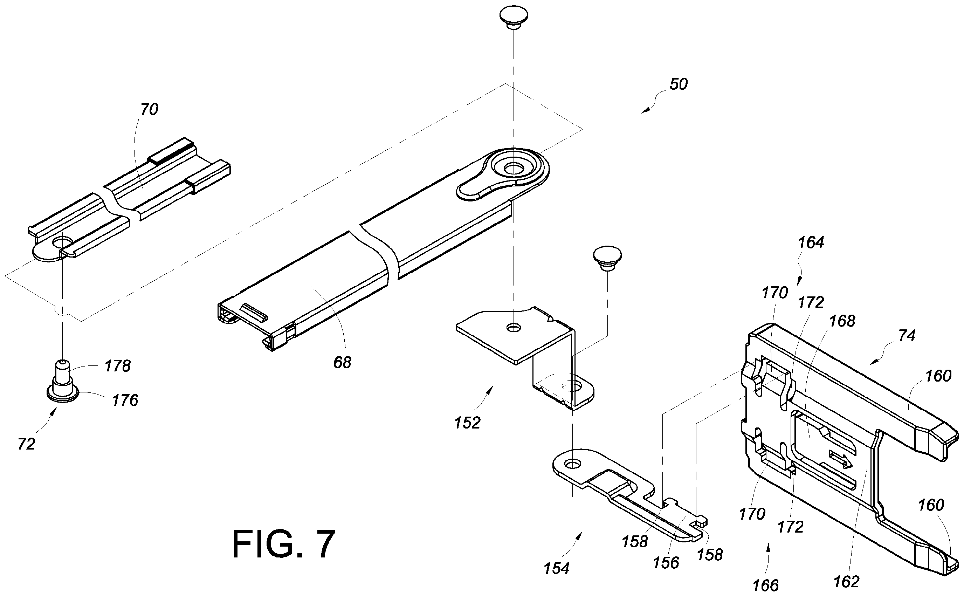

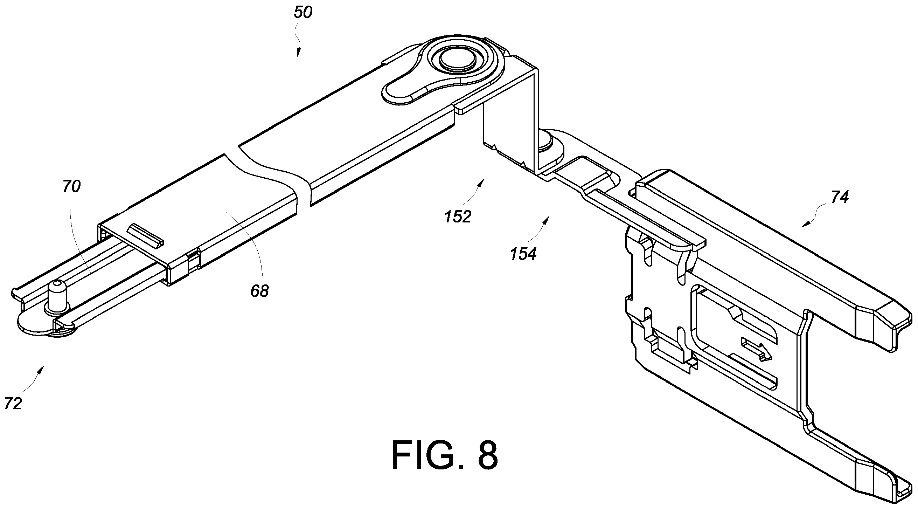

Referring to FIG. 7 and FIG. 8 for a schematic exploded view and an assembled perspective view of the first supporting mechanism 50 respectively, the first supporting mechanism 50 further includes a hinge structure 152 and a swing arm 154. The hinge structure 152 is connected between the first supporting rail 68 and the swing arm 154, and the swing arm 154 is connected between the hinge structure 152 and the movable member 74, thus allowing the movable member 74 to rotate with respect to the first supporting rail 68. More specifically, the swing arm 154 has an engaging projection 156 and two engaging grooves 158, wherein the two engaging grooves 158 are located on two lateral sides of the engaging projection 156 respectively. The movable member 74 is formed of a flexible material such as plastic and includes a pair of sidewalls 160 and a lateral wall 162 extending between the pair of sidewalls 160. The lateral wall 162 has an upper engaging feature 164, a lower engaging feature 166, and an operation portion 168. During assembly, the engaging projection 156 of the swing arm 154 is engaged with, and thus fixed position with respect to, one of the upper engaging feature 164 and the lower engaging feature 166. More particularly, each of the engaging features 164 and 166 has an elastic block 170 and a groove 172 extending along the periphery of the elastic block 170. In this embodiment, the engaging projection 156 is inserted into the groove 172 of the upper engaging feature 164 such that not only is the wall of the movable member 74 engaged in the engaging grooves 158, but also the elastic block 170 presses against the engaging projection 156; consequently, the movable member 74 and the swing arm 154 are engaged with and fixed in position with respect to each other. And because of that, the first supporting mechanism 50 is located at a higher position than the movable member 74. For disassembly, the operator only has to press the elastic block 170 to release the elastic block 170 from engagement with the engaging projection 156, and the movable member 74 can be removed from the swing arm 154. Furthermore, the fastener 72 is fixedly connected to the second supporting rail 70 of the first supporting mechanism 50. The fastener 72 has a head 176 and a body 178 extending from the head 176. The outer diameter of the head 176 is greater than the outer diameter of the body 178.

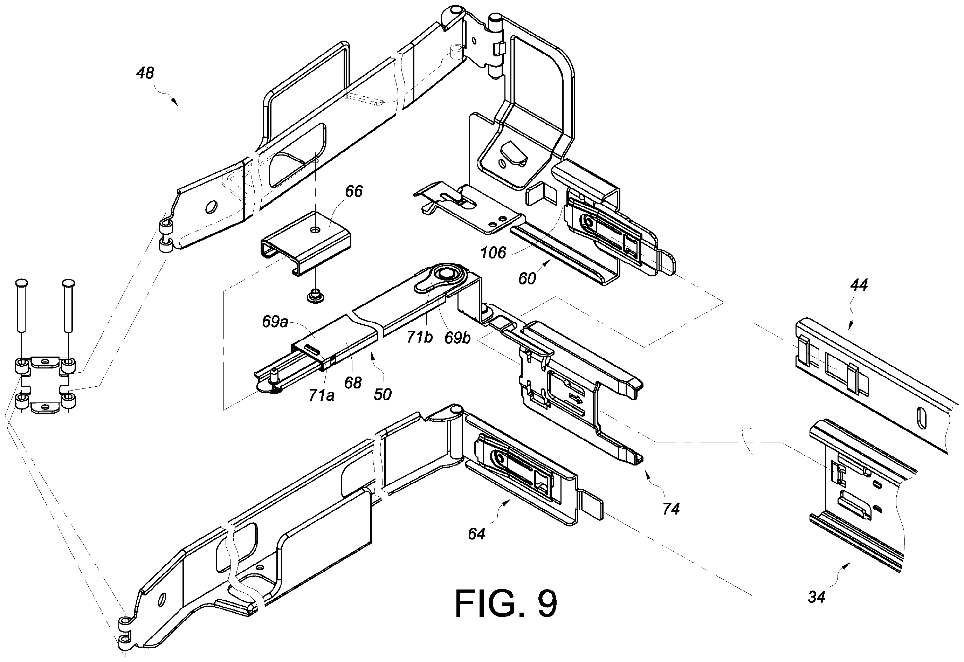

FIG. 9 shows how the first connecting section 106 of the first connecting device 60 of the first cable management mechanism 48 and the movable member 74 of the first supporting mechanism 50 can be jointly mounted to the first slide rail assembly 34, and how the second connecting device 64 of the first cable management mechanism 48 can be mounted to the first connecting base 44, which is adjacent to a lateral side of the chassis 32. The first supporting rail 68 of the first supporting mechanism 50 includes a first portion 69a and a second portion 69b. Each of the first portion 69a and the second portion 69b has a position-limiting element (e.g., a first position-limiting element 71a and a second position-limiting element 71b respectively). Thus, the slider 66 of the first cable management mechanism 48 is limited between the position-limiting elements when displaced along the first supporting rail 68 of the first supporting mechanism 50.

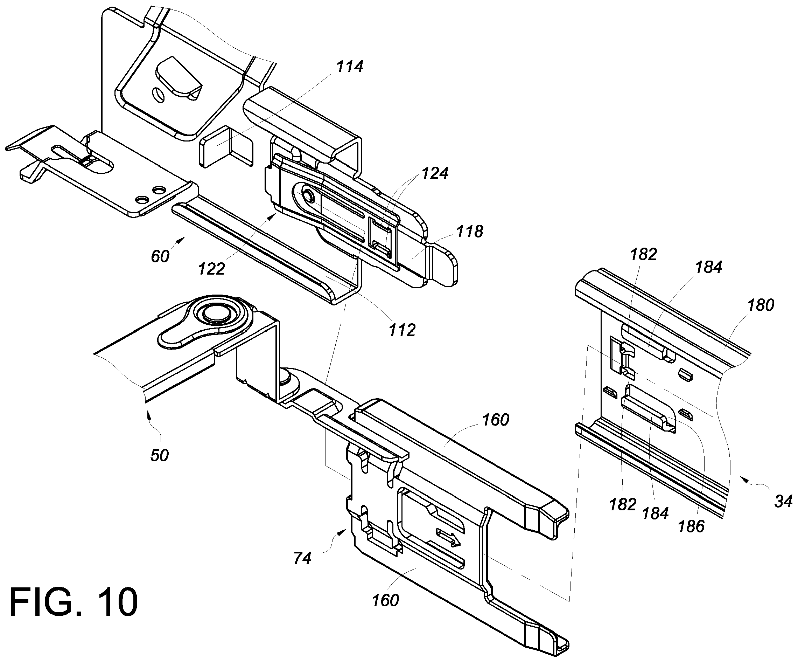

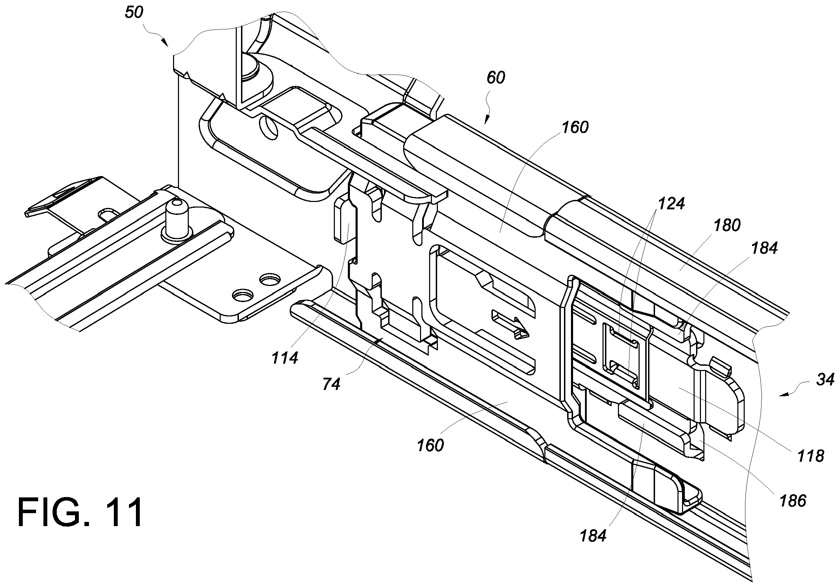

Referring to FIG. 10 and FIG. 11, the first connecting device 60 of the first cable management mechanism 48 and the movable member 74 of the first supporting mechanism 50 can be jointly mounted to one of the rails (e.g., a fixed rail 180) of the first slide rail assembly 34. The fixed rail 180 has a pair of connecting holes 182. Preferably, the fixed rail 180 further includes at least one pair of curved fixing elements 184, and the pair of fixing elements 184 define a channel 186. During assembly, the two sidewalls 160 of the movable member 74 of the first supporting mechanism 50 are mounted into the passage 112 of the first connecting device 60 of the first cable management mechanism 48 such that the movable member 74 of the first supporting mechanism 50 is pressed against the stop portion 114 of the first connecting device 60 and thus reaches a retracted position relative to the first connecting device 60 and the fixed rail 180 of the first slide rail assembly 34. In this position, the at least one engaging portion 124 of the engaging member 122 is correspondingly engaged with the pair of connecting holes 182 of the fixed rail 180, and the inserting portion 118 of the first connecting device 60 of the first cable management mechanism 48 is correspondingly inserted into the channel 186 of the fixed rail 180 of the first slide rail assembly 34 and stopped by the pair of fixing elements 184. Consequently, the first connecting device 60 of the first cable management mechanism 48 is securely mounted to the fixed rail 180 of the first slide rail assembly 34, allowing the movable member 74 of the first supporting mechanism 50 to stay within the first connecting device 60 of the first cable management mechanism 48 and the fixed rail 180 of the first slide rail assembly 34.

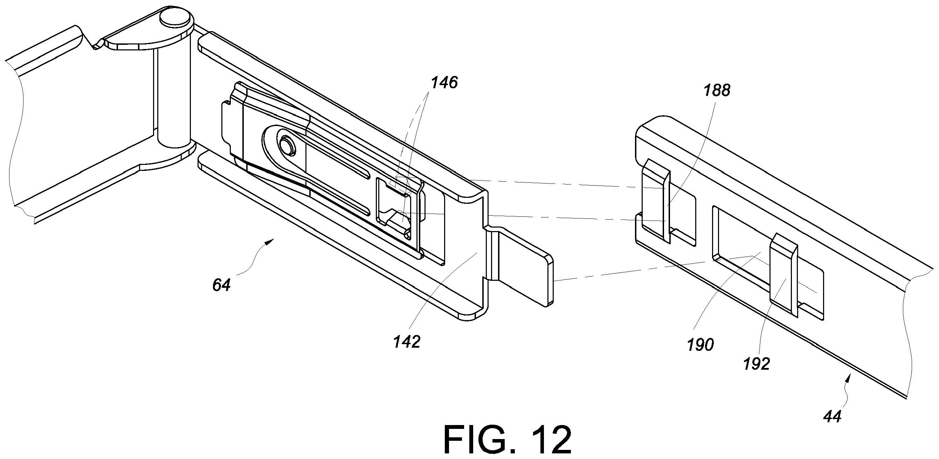

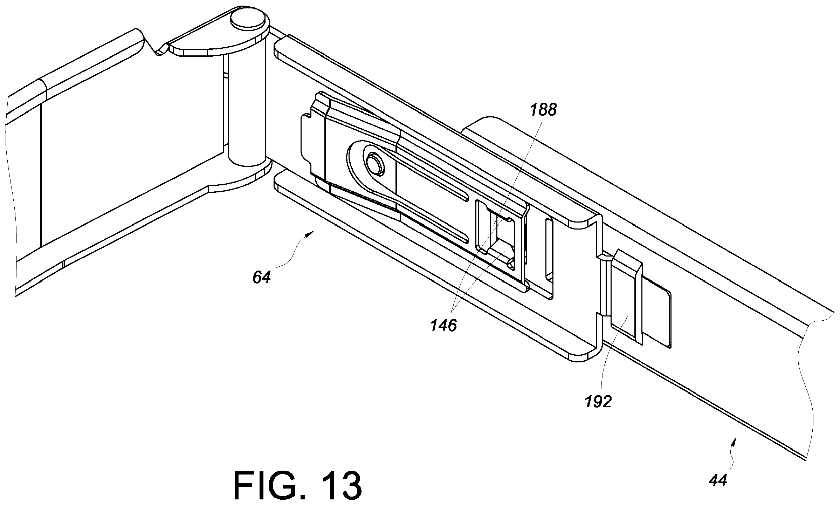

Referring to FIG. 12 and FIG. 13, the first connecting base 44 on a lateral side of the chassis 32 includes a stop portion 188 and preferably further includes an insertion opening 190 and a stop wall 192. During assembly, the engaging portion 146 of the second connecting device 64 of the first cable management mechanism 48 is correspondingly engaged with the stop portion 188 of the first connecting base 44, and the inserting portion 142 of the second connecting device 64 of the first cable management mechanism 48 is correspondingly inserted into the insertion opening 190 of the first connecting base 44 and stopped by the stop wall 192. In consequence, the second connecting device 64 of the first cable management mechanism 48 is securely mounted to the first connecting base 44.

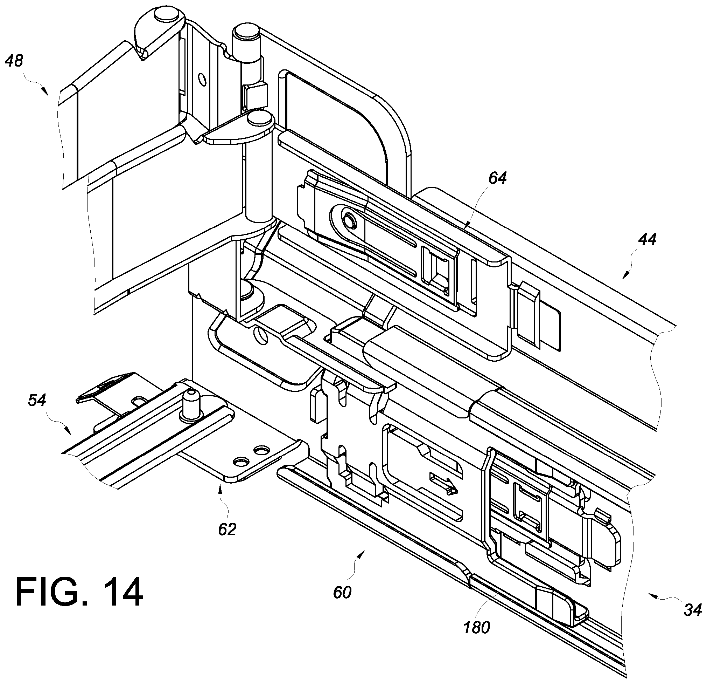

In FIG. 14, the first connecting device 60 and the second connecting device 64 of the first cable management mechanism 48 are respectively mounted to the fixed rail 180 of the first slide rail assembly 34 and the first connecting base 44. In addition, the second supporting mechanism 54 is mounted to the supporting bracket 62 of the first cable management mechanism 48.

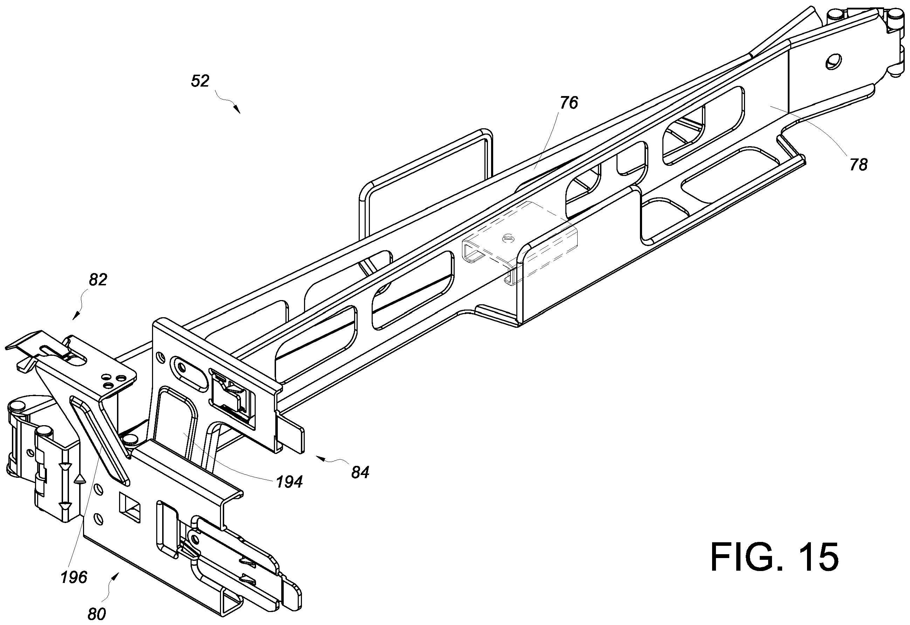

FIG. 15 is an assembled perspective view of the second cable management mechanism 52. The second cable management mechanism 52 is different from the first cable management mechanism 48 generally in that the second cable management mechanism 52 includes a first extension 194 and a second extension 196. The first extension 194 is connected to the second connecting device 84 such that the second connecting device 84 is at a higher position than the second arm member 78 of the second cable management mechanism 52. The second extension 196 is connected to the supporting bracket 82 such that the supporting bracket 82 is located above the first connecting device 80 of the second cable management mechanism 52.

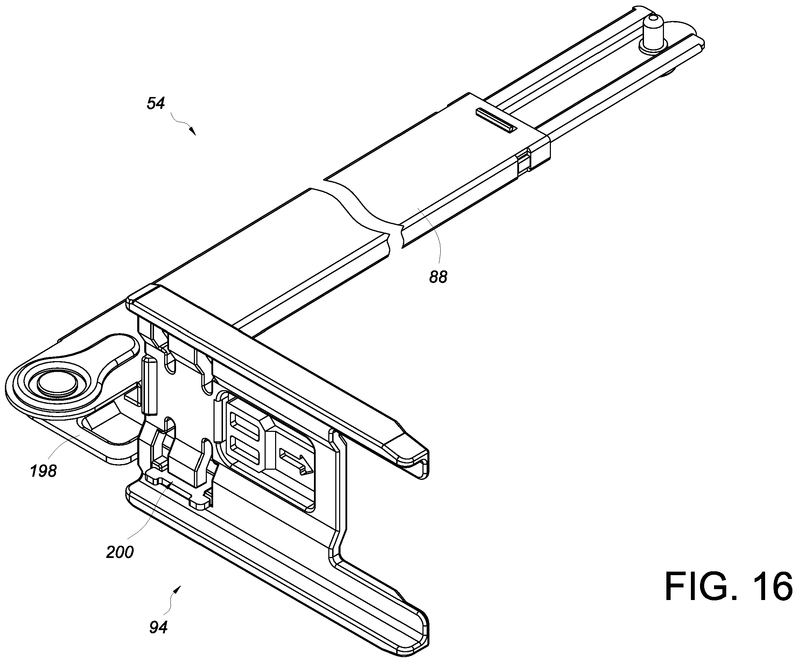

FIG. 16 is a schematic assembled view of the second supporting mechanism 54. The second supporting mechanism 54 is different from the first supporting mechanism 50 generally in that the second supporting mechanism 54 has a swing arm 198 movably connected between the movable member 94 and the first supporting rail 88 of the second supporting mechanism 54. The swing arm 198 has one end engaged with a lower engaging feature 200 of the movable member 94 such that the movable member 94 is at a higher position than the second supporting mechanism 54.

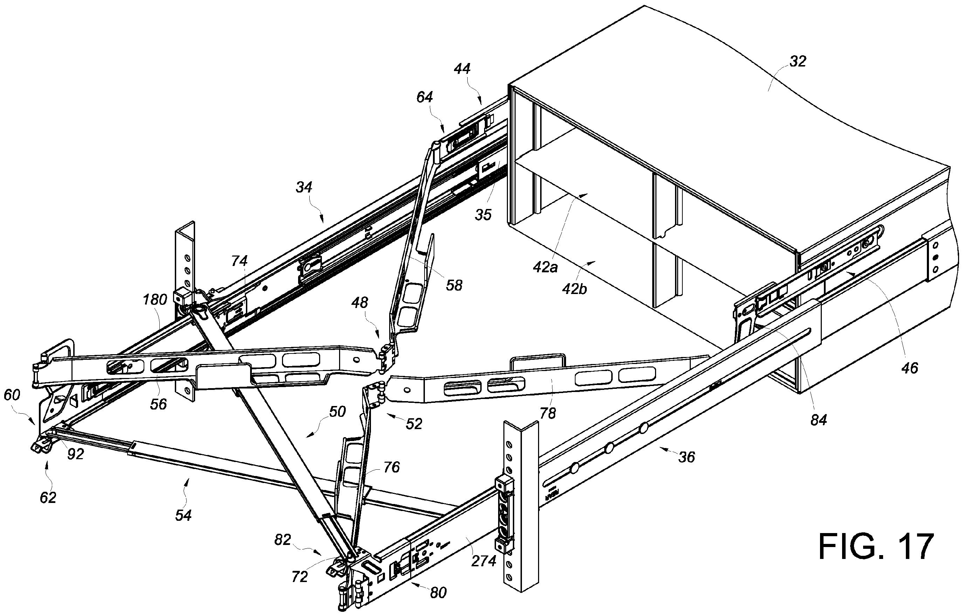

As shown in FIG. 17, the first connecting device 60 of the first cable management mechanism 48 is generally parallel to the first connecting device 80 of the second cable management mechanism 52 (e.g., the first connecting device 60 of the first cable management mechanism 48 and the first connecting device 80 of the second cable management mechanism 52 being on the same horizontal plane). Meanwhile, the supporting bracket 62 of the first cable management mechanism 48 is adjacent to and below the first connecting device 60 of the first cable management mechanism 48. Therefore, by mounting the fastener 92 of the second supporting mechanism 54 to the supporting bracket 62 of the first cable management mechanism 48, the second cable management mechanism 52 is arranged below the first cable management mechanism 48. On the other hand, the supporting bracket 82 of the second cable management mechanism 52 is adjacent to and above the first connecting device 80 of the second cable management mechanism 52 so that, by mounting the fastener 72 of the first supporting mechanism 50 to the supporting bracket 82 of the second cable management mechanism 52, the first cable management mechanism 48 is arranged above the second cable management mechanism 52. Hence, the first arm member 56 and the second arm member 58 of the first cable management mechanism 48 generally correspond in position, and are applicable, to the upper-tier area 42a of the chassis 32 and serve to hold cables connected to or extending from the rear side of the upper-tier area 42a of the chassis 32. On the other hand, the first arm member 76 and the second arm member 78 of the second cable management mechanism 52 generally correspond in position, and are applicable, to the lower-tier area 42b of the chassis 32 and serve to hold cables connected to or extending from the rear side of the lower-tier area 42b of the chassis 32.

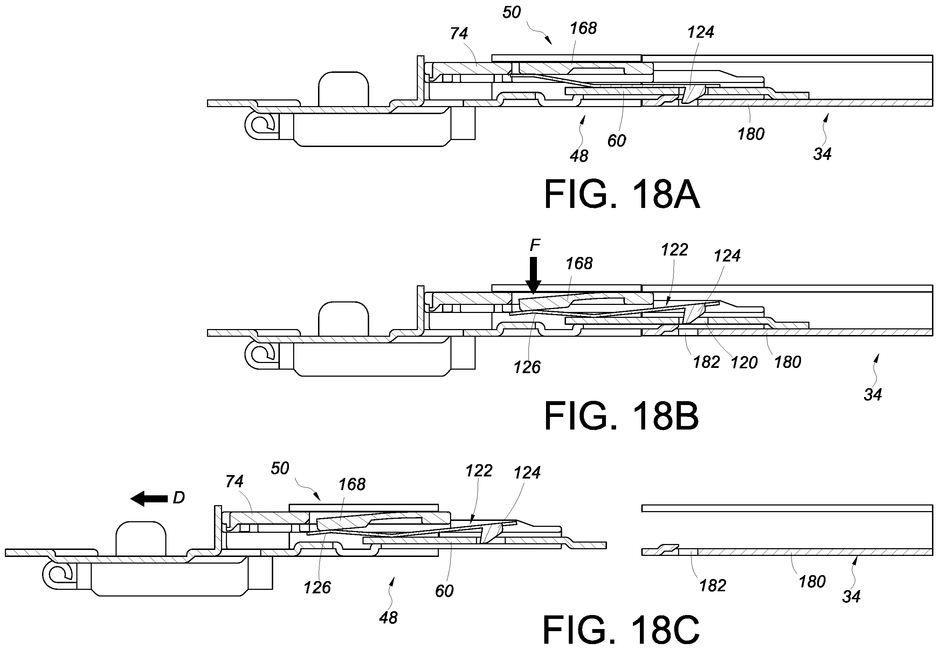

FIG. 18A∼FIG. 18C show how the first connecting device 60 of the first cable management mechanism 48 and the movable member 74 of the first supporting mechanism 50 are jointly mounted to the fixed rail 180 of the first slide rail assembly 34 in a releasable manner. To release the foregoing elements from the connected state, the operator can operate the releasing portion 126 of the engaging member 122 by applying a force F thereto indirectly (i.e., through the operation portion 168 of the movable member 74 of the first supporting mechanism 50) while the movable member 74 of the first supporting mechanism 50 is at a retracted position relative to the first connecting device 60 of the first cable management mechanism 48, and the at least one engaging portion 124 of the engaging member 122 will be disengaged from the at least one connecting hole 182 of the fixed rail 180 and from the at least one engaging hole 120 of the first connecting device 60. Then, the first connecting device 60 of the first cable management mechanism 48 and the movable member 74 of the first supporting mechanism 50 can be moved together in a direction D in order to be detached from the fixed rail 180 of the first slide rail assembly 34.

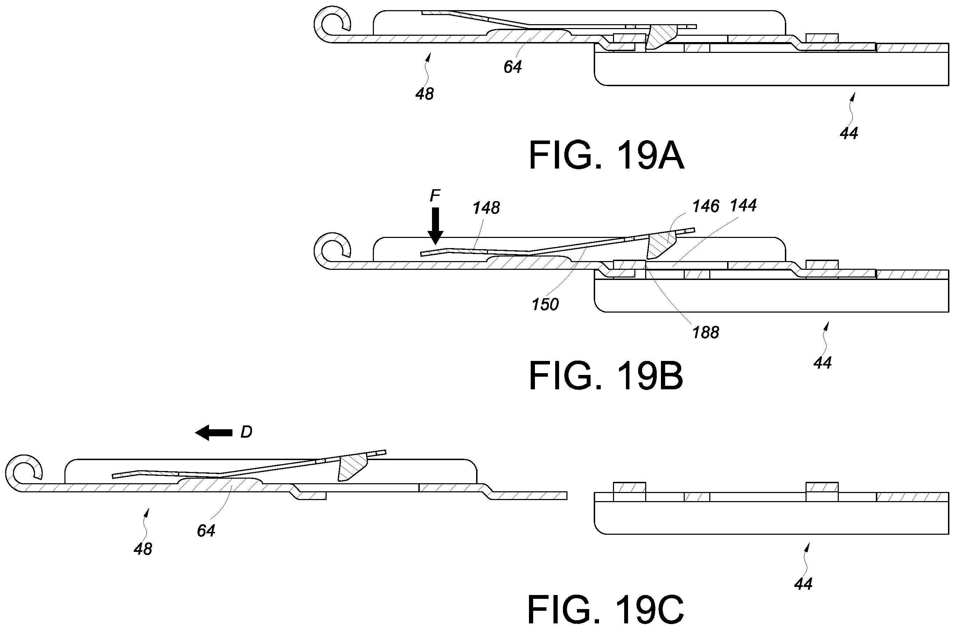

Referring to FIG. 19A∼FIG. 19C, when it is desired to release the second connecting device 64 of the first cable management mechanism 48 and the first connecting base 44 from the connected state, the operator can operate the releasing portion 148 of the second connecting device 64 by applying a force F thereto to overcome the elastic force provided by the elastic portion 150 of the second connecting device 64, thereby disengaging the at least one engaging portion 146 of the second connecting device 64 from the engaging hole 144 of the connecting member 138 and from the stop portion 188 of the first connecting base 44. Then, the second connecting device 64 of the first cable management mechanism 48 can be detached from the first connecting base 44 in a direction D.

After the second connecting device 64 of the first cable management mechanism 48 is released from the first connecting base 44 on the chassis 32, the electronic parts and/or equipment in the upper-tier area 42a of the chassis 32 can be inspected, repaired, or replaced with ease. Similarly, the electronic parts and/or equipment in the lower-tier area 42b of the chassis 32 can be easily inspected, repaired, or replaced once the second connecting device 84 of the second cable management mechanism 52 is released from the second connecting base 46 on the chassis 32.

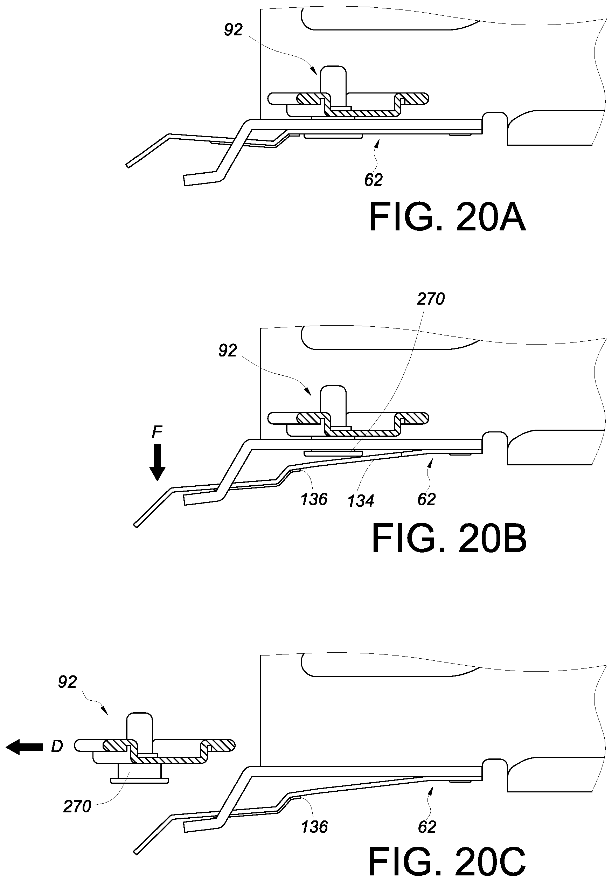

Referring to FIG. 20A∼FIG. 20C, if it is desired to release the fastener 92 of the second supporting mechanism 54 and the supporting bracket 62 of the first cable management mechanism 48 from the connected state, in which the head 270 of the fastener 92 of the second supporting mechanism 54 is mounted in the positioning hole 130 of the supporting bracket 62 of the first cable management mechanism 48 (see FIG. 5 and FIG. 5A), the operator can operate the positioning member 134 of the first connecting device 60 of the first cable management mechanism 48 by applying a force F thereto such that the blocking portion 136 of the positioning member 134 no longer blocks the head 270 of the fastener 92 of the second supporting mechanism 54. Then, the second supporting mechanism 54 can be moved in a direction D so as to be detached from the supporting bracket 62 of the first cable management mechanism 48.

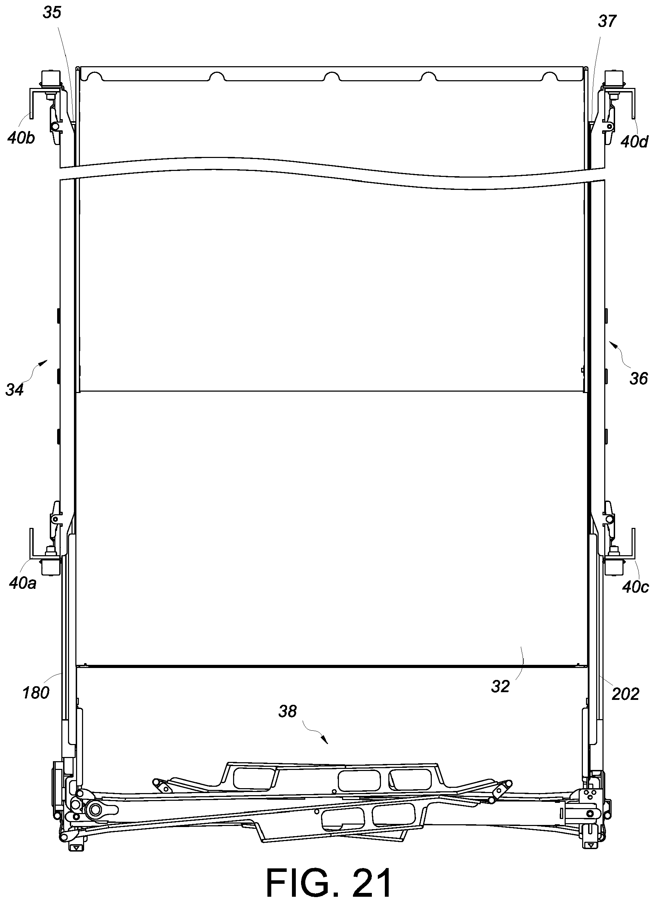

Referring to FIG. 21, the cable management arm 38 is in a folded state when the movable rails of slide rail assemblies (e.g., the movable rail 35 of the first slide rail assembly 34 and a movable rail 37 of the second slide rail assembly 36) are at a retracted position relative to the fixed rails of the slide rail assemblies (e.g., the fixed rail 180 of the first slide rail assembly 34 and a fixed rail 202 of the second slide rail assembly 36).

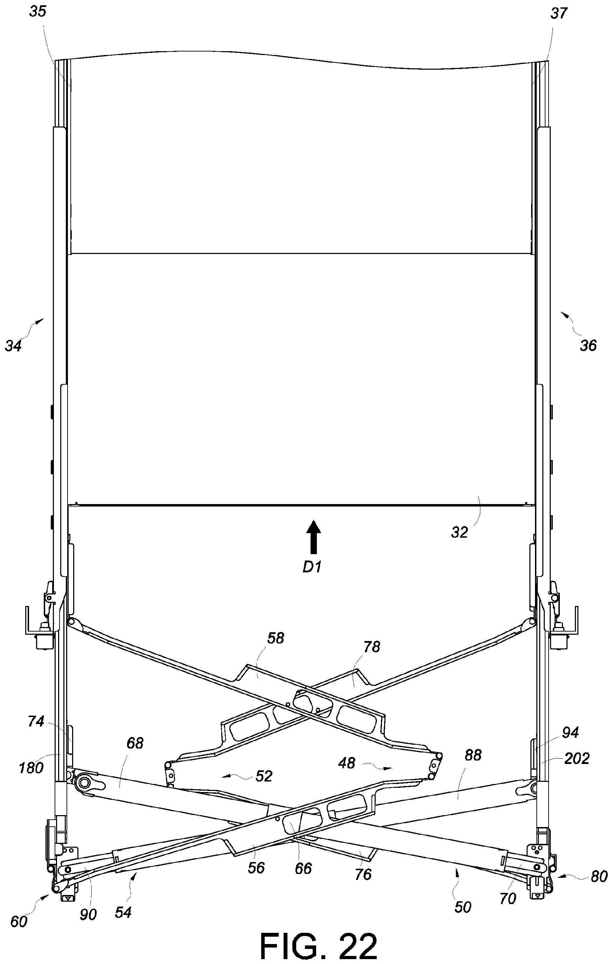

Referring to FIG. 22, when the movable rails of the slide rail assemblies (e.g., the movable rail 35 of the first slide rail assembly 34 and the movable rail 37 of the second slide rail assembly 36) are longitudinally displaced in a direction D1 from the retracted position toward an extended position relative to the fixed rails (e.g., the fixed rail 180 of the first slide rail assembly 34 and the fixed rail 202 of the second slide rail assembly 36), the chassis 32 is displaced with the movable rails. Consequently, the second arm member 58 of the first cable management mechanism 48 is gradually extended relative to the first arm member 56, and the second arm member 78 of the second cable management mechanism 52 is gradually extended relative to the first arm member 76. In the meantime, the slider 66 and the slider 86 (not shown) drive the first supporting rail 68 of the first supporting mechanism 50 and the first supporting rail 88 of the second supporting mechanism 54 respectively, and the movable member 74 and the movable member 94 are displaced in the direction D1 toward the extended position within the fixed rail 180 of the first slide rail assembly 34 and the fixed rail 202 of the second slide rail assembly 36 relative to the first connecting device 60 and the first connecting device 80 respectively. As to the first and the second supporting mechanisms 50 and 54, their first supporting rails 68 and 88 are linearly extended relative to the second supporting rails 70 and 90 while supporting the first arm member 56 of the first cable management mechanism 48 and the first arm member 76 of the second cable management mechanism 52 respectively.

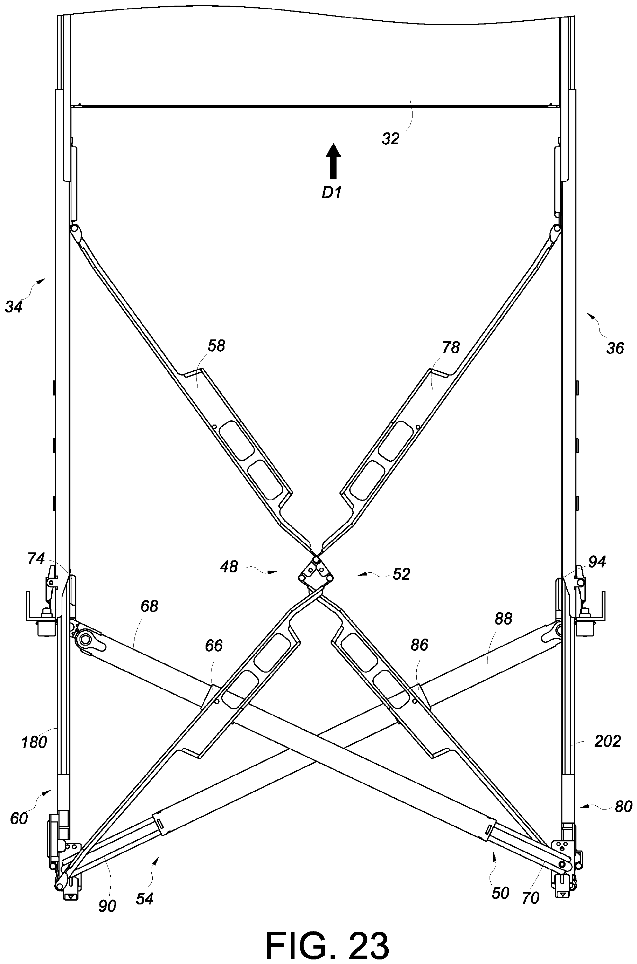

Referring to FIG. 23, when the movable rails of the slide rail assemblies are further displaced in the direction D 1 toward the extended position relative to the fixed rails (e.g., the fixed rail 180 of the first slide rail assembly 34 and the fixed rail 202 of the second slide rail assembly 36), the second arm member 58 of the first cable management mechanism 48 is further extended relative to the first arm member 56, and the second arm member 78 of the second cable management mechanism 52 is further extended relative to the first arm member 76. At the same time, the sliders 66 and 86 further drive the first supporting rail 68 of the first supporting mechanism 50 and the first supporting rail 88 of the second supporting mechanism 54 respectively, and the movable members 74 and 94 are further displaced in the direction D 1 toward the extended position within the fixed rail 180 of the first slide rail assembly 34 and the fixed rail 202 of the second slide rail assembly 36 relative to the first connecting devices 60 and 80 respectively. Also, the first supporting rail 68 of the first supporting mechanism 50 and the first supporting rail 88 of the second supporting mechanism 54 are further linearly extended relative to the second supporting rail 70 and the second supporting rail 90 respectively while supporting the first arm member 56 of the first cable management mechanism 48 and the first arm member 76 of the second cable management mechanism 52 respectively.

It is worth mentioning that, when the movable rails of the slide rail assemblies are displaced toward the retracted position relative to the fixed rails (e.g., the fixed rail 180 of the first slide rail assembly 34 and the fixed rail 202 of the second slide rail assembly 36) (i.e., in a direction opposite the direction D1 toward the extended position), the second arm member 58 of the first cable management mechanism 48 and the second arm member 78 of the second cable management mechanism 52 are retracted relative to the first arm member 56 of the first cable management mechanism 48 and the first arm member 76 of the second cable management mechanism 52 respectively. As a result, the first supporting rail 68 of the first supporting mechanism 50 and the first supporting rail 88 of the second supporting mechanism 54 are brought back to the retracted state relative to the second supporting rail 70 of the first supporting mechanism 50 and the second supporting rail 90 of the second supporting mechanism 54 respectively.

While the present invention has been disclosed through the foregoing preferred embodiments, it is understood that the embodiments are not intended to be restrictive of the invention. The scope of patent protection sought is defined by the appended claims.

## Claims

1. A cable management arm (38), comprising:
a first cable management mechanism (48) including: a first arm member (56); a second arm member (58) movably connected to the first arm member (56); a first connecting device (60) movably connected to the first arm member (56) and a second connecting device (64) movably connected to the second arm member (58);,
a second cable management mechanism (52) including: a first arm member (76); a second arm member (78) movably connected to the first arm member (76); a first connecting device (80) movably connected to the first arm member (76), and a second connecting device (84) movably connected to the second arm member (78);
**characterized in that**
the first connecting device (60) of the first cable management mechanism (48) further includes a first connecting section (106), a second connecting section (108), and a passage (112) at the first connecting section (106);
and that the first cable management mechanism (48) further includes a supporting bracket (62) connected to the second connecting section (108);
and that the first connecting device (80) of the second cable management mechanism (52) further includes an extension (196);
and that the cable management arm (38) further comprises a first supporting mechanism (50) and a second supporting mechanism (54),
wherein the first supporting mechanism (50) includes: a first supporting rail (68) for supporting one of the first arm member (56) and the second arm member (58) of the first cable management mechanism (48); a second supporting rail (70) telescopically connected to the first supporting rail (68); a movable member (74) connected to the first supporting rail (68), the movable member (74) being movably mounted to the passage (112) of the first connecting device (60) of the first cable management mechanism (48); and a fastener (72) connected to the second supporting rail (70);
wherein the second supporting mechanism (54) includes: a first supporting rail (88) for supporting one of the first arm member (76) and the second arm member (78) of the second cable management mechanism (52); a second supporting rail (90) telescopically connected to the first supporting rail (88); a movable member (94) connected to the first supporting rail (88), the movable member (94) being movably mounted to the first connecting device (80) of the second cable management mechanism (52); and a fastener (92) connected to the second supporting rail (90), the fastener (92) being releasably mounted to the supporting bracket (62) of the first cable management mechanism (48); and
wherein the second cable management mechanism (52) further includes a supporting bracket (82) connected to the extension (196), the supporting bracket (82) being releasably connected to the fastener (72) of the first supporting mechanism (50).

2. The cable management arm (38) as claimed in claim 1, wherein the cable management arm (38) is applicable to a chassis (32), the chassis (32) including an upper-tier area (42a) and a lower-tier area (42b), the chassis (32) having two opposite lateral sides mounted to a rack (30) via a first slide rail assembly (34) and a second slide rail assembly (36) respectively, each said slide rail assembly (34, 36) including a fixed rail (180, 202) and a movable rail (35, 37) longitudinally displaceable with respect to the fixed rail (180, 202), the two opposite lateral sides of the chassis (32) being mounted to the movable rails (35, 37) of the slide rail assemblies (34, 36) respectively; wherein the first arm member (56) and the second arm member (58) of the first cable management mechanism (48) generally correspond in position to the upper-tier area (42a) of the chassis (32), while the first arm member (76) and the second arm member (78) of the second cable management mechanism (52) generally correspond in position to the lower-tier area (42b) of the chassis (32); and wherein the first connecting device (60) of the first cable management mechanism (48) is releasably mounted to the fixed rail (180) of the first slide rail assembly (34), the second connecting device (64) of the first cable management mechanism (48) is releasably mounted to the chassis (32), the first connecting device (80) of the second cable management mechanism (52) is releasably mounted to the fixed rail (202) of the second slide rail assembly (36), and the second connecting device (84) of the second cable management mechanism (52) is releasably mounted to the chassis (32).

3. The cable management arm (38) as claimed in claim 1 or 2, wherein the supporting bracket (62) of the first cable management mechanism (48) is adjacent to and below the first connecting device (60) of the first cable management mechanism (48) such that, with the fastener (92) of the second supporting mechanism (54) mounted to the supporting bracket (62) of the first cable management mechanism (48), the second cable management mechanism (52) lies below the first cable management mechanism (48); and wherein the supporting bracket (82) of the second cable management mechanism (52) is adjacent to and above the first connecting device (80) of the second cable management mechanism (52) such that, with the fastener (72) of the first supporting mechanism (50) mounted to the supporting bracket (82) of the second cable management mechanism (52), the first cable management mechanism (48) lies above the second cable management mechanism (52).

4. The cable management arm (38) as claimed in claim 2, wherein the two opposite lateral sides of the chassis (32) are respectively connected with a first connecting base (44) and a second connecting base (46), each said connecting base (44, 46) includes a stop portion (188), and each of the second connecting device (64) of the first cable management mechanism (48) and the second connecting device (84) of the second cable management mechanism (52) further includes an elastic portion (150), an engaging portion (146) engageable with the stop portion (188) of a corresponding said connecting base (44, 46) in response to an elastic force provided by the elastic portion (150), and a releasing portion (148) for disengaging the engaging portion (146) from the stop portion (188) of the corresponding connecting base (44, 46).

5. The cable management arm (38) as claimed in claim 4, wherein each said connecting base (44, 46) further includes an insertion opening (190) and a stop wall (192), and each of the second connecting device (64) of the first cable management mechanism (48) and the second connecting device (84) of the second cable management mechanism (52) further includes an inserting portion (142) insertable into the insertion opening (190), and stoppable by the stop wall (192), of the corresponding connecting base (44, 46).

6. The cable management arm (38) as claimed in claim 2, wherein the fixed rail (180, 202) of each said slide rail assembly (34, 36) includes a connecting hole (182), and each of the first connecting device (60) of the first cable management mechanism (48) and the first connecting device (80) of the second cable management mechanism (52) further includes an elastic portion (128), an engaging portion (124) engageable with the connecting hole (182) of a corresponding said fixed rail (180, 202) in response to an elastic force provided by the elastic portion (128), and a releasing portion (126) for disengaging the engaging portion (124) from the connecting hole (182) of the corresponding fixed rail (180, 202).

7. The cable management arm (38) as claimed in claim 6, wherein the fixed rail (180, 202) of each said slide rail assembly (34, 36) further includes a pair of fixing elements (184) which define a channel (186), and each of the first connecting device (60) of the first cable management mechanism (48) and the first connecting device (80) of the second cable management mechanism (52) further includes an inserting portion (118) insertable into the channel (186), and stoppable by the pair of fixing elements (184), of the corresponding fixed rail (180, 202).

8. The cable management arm (38) as claimed in claim 6, wherein each of the movable member (74) of the first supporting mechanism (50) and the movable member (94) of the second supporting mechanism (54) includes an operation portion (168); when the movable rails (35, 37) of the slide rail assemblies (34, 36) are retracted to a retracted position relative the fixed rails (180, 202), the movable member (74) of the first supporting mechanism (50) and the movable member (94) of the second supporting mechanism (54) are displaced relative to the first connecting device (60) of the first cable management mechanism (48) and the first connecting device (80) of the second cable management mechanism (52) respectively and are thus retracted; and each of the engaging portion (124) of the first connecting device (60) of the first cable management mechanism (48) and the engaging portion of the first connecting device (80) of the second cable management mechanism (52) is disengageable from the connecting hole (182) of the corresponding fixed rail (180, 202) in response to a corresponding said operation portion (168) being operated to drive a corresponding said releasing portion (126).

9. The cable management arm (38) as claimed in claim 1 or 2, wherein the supporting bracket (62) of the first cable management mechanism (48) includes a positioning hole (130) and a positioning member (134) elastically connected to the supporting bracket (62) of the first cable management mechanism (48) and having a blocking portion (136) corresponding to the positioning hole (130), and the supporting bracket (82) of the second cable management mechanism (52) includes a positioning hole and a positioning member elastically connected to the supporting bracket (82) of the second cable management mechanism (52) and having a blocking portion corresponding to the positioning hole; and wherein the fastener (72) of the first supporting mechanism (50) is mounted to the positioning hole of the supporting bracket (82) of the second cable management mechanism (52) and is blocked by the blocking portion of the positioning member of the second cable management mechanism (52), and the fastener (92) of the second supporting mechanism (54) is mounted to the positioning hole (130) of the supporting bracket (62) of the first cable management mechanism (48) and is blocked by the blocking portion (136) of the positioning member (134) of the first cable management mechanism (48).

10. The cable management arm (38) as claimed in claim 1 or 2, wherein each of the first cable management mechanism (48) and the second cable management mechanism (52) further includes a slider (66, 86), the slider (66) of the first cable management mechanism (48) is pivotally connected to the first arm member (56) of the first cable management mechanism (48) and is movably connected to the first supporting rail (68) of the first supporting mechanism (50), and the slider (86) of the second cable management mechanism (52) is pivotally connected to the first arm member (76) of the second cable management mechanism (52) and is movably connected to the first supporting rail (88) of the second supporting mechanism (54).

11. The cable management arm (38) as claimed in claim 10, wherein each of the first supporting rail (68) of the first supporting mechanism (50) and the first supporting rail (88) of the second supporting mechanism (54) includes a first portion (69a) with a position-limiting element (71a) and a second portion (69b) with a position-limiting element (71b) so that, when displaced along the first supporting rail (68) of the first supporting mechanism (50) and the first supporting rail (88) of the second supporting mechanism (54) respectively, the slider (66) of the first cable management mechanism (48) and the slider (86) of the second cable management mechanism (52) are each limited between a corresponding said first portion and a corresponding said second portion by corresponding said position-limiting elements.

12. The cable management arm (38) as claimed in claim 1 or 2, wherein the fastener (72) of the first supporting mechanism (50) is connected to the second supporting rail (70) of the first supporting mechanism (50) at a position adjacent to an end portion of the second supporting rail (70) of the first supporting mechanism (50).

13. The cable management arm (38) as claimed in claim 1 or 2, wherein the fastener (92) of the second supporting mechanism (54) is connected to the second supporting rail (90) of the second supporting mechanism (54) at a position adjacent to an end portion of the second supporting rail (90) of the second supporting mechanism (54).

14. The cable management arm (38) as claimed in claim 1, wherein the first connecting device (60) of first cable management mechanism (48) includes at least one engaging hole (120) and an engaging member (122); wherein the engaging member (122) has an elastic portion (128), at least one engaging portion (124) engageable with the at least one engaging hole (120) in response to an elastic force provided by the elastic portion (128), and a releasing portion (126) for disengaging the at least one engaging portion (124) from the at least one engaging hole (120); wherein the movable member (74) includes an operation portion (168) and is displaceable relative to the first connecting device (60) of first cable management mechanism (48); and wherein when the movable member (74) has been displaced to a retracted position relative to the first connecting device (60) of first cable management mechanism (48), the at least one engaging portion (124) of the engaging member (122) is disengageable from the at least one engaging hole (120) of the first connecting device (60) of first cable management mechanism (48) in response to the operation portion (168) being operated to drive the releasing portion (126).

## Patentansprüche

1. Ein Kabelaufwickelarm (38), umfassend:
einen ersten Kabelaufwickelmechanismus (48), der aus den folgenden Komponenten besteht: ein erstes Armglied (56); ein zweites Armglied (58), das beweglich am ersten Armglied (56) befestigt ist; wobei eine erste Verbindungsvorrichtung (60) beweglich am ersten Armglied (56) und eine zweite Verbindungsvorrichtung (64) beweglich am zweiten Armglied (58) befestigt sind;
ein zweiter Kabelaufwickelmechanismus (52), der aus den folgenden Komponenten besteht: ein erstes Armglied (76); ein zweites Armglied (78), das beweglich am ersten Armglied (76) befestigt ist; wobei eine erste Verbindungsvorrichtung (80) beweglich am ersten Armglied (76) und eine zweite Verbindungsvorrichtung (84) beweglich am zweiten Armglied (78) befestigt sind;
**dadurch gekennzeichnet, dass**
die erste Verbindungsvorrichtung (60) des ersten Kabelaufwickelmechanismus' (48) weiter einen ersten Verbindungsabschnitt (106), einen zweiten Verbindungsabschnitt (108) und einen Durchgang (112) am ersten Verbindungsabschnitt (106) aufweist;
der erste Kabelaufwickelmechanismus (48) weiter eine Stützklammer (62), die am zweiten Verbindungsabschnitt (108) befestigt ist, aufweist;
die erste Verbindungsvorrichtung (80) des zweiten Kabelaufwickelmechanismus' (52) weiter eine Verlängerung (196) aufweist;
der Kabelaufwickelarm (38) weiter einen ersten Stützmechanismus (50) und einen zweiten Stützmechanismus (54) umfasst;
worin der erste Stützmechanismus (50) aus den folgenden Komponenten besteht: eine erste Tragschiene (68) zum Tragen eines der ersten Armglieder (56) und der zweiten Armglieder (58) des ersten Kabelaufwickelmechanismus' (48); eine zweite Tragschiene (70) teleskopisch an der ersten Tragschiene (68) befestigt ist; ein bewegliches Glied (74) an der ersten Tragschiene (68) befestigt ist; das bewegliche Glied (74) beweglich am Durchgang (112) der ersten Verbindungsvorrichtung (60) des ersten Kabelaufwickelmechanismus' (48) montiert ist; ein Verbindungselement (72) an der zweiten Tragschiene (70) befestigt ist;
worin der zweite Stützmechanismus (54) aus den folgenden Komponenten besteht: eine erste Tragschiene (88) zum Tragen eines der ersten Armglieder (76) und der zweiten Armglieder (78) des zweiten Kabelaufwickelmechanismus' (52); eine zweite Tragschiene (90) teleskopisch an der ersten Tragschiene (88) befestigt ist; ein bewegliches Glied (94) an der ersten Tragschiene (88) befestigt ist; das bewegliche Glied (94) beweglich an der ersten Verbindungsvorrichtung (80) des zweiten Kabelaufwickelmechanismus' (52) befestigt ist; ein Verbindungselement (92) an der zweiten Tragschiene (90) befestigt ist; das Verbindungselement (92) lösbar an der Stützklammer (62) des ersten Kabelaufwickelmechanismus' (48) montiert ist; und
worin der zweite Kabelaufwickelmechanismus (52) weiter aus einer Stützklammer (82), die an der Verlängerung (196) befestigt ist, besteht; die Stützklammer (82) lösbar am Verbindungselement (72) des ersten Stützmechanismus' (50) befestigt ist.

2. Der Kabelaufwickelarm (38) nach Anspruch 1, worin der Kabelaufwickelarm (38) an einem Fahrwerk (32) verwendet werden kann; das Fahrwerk (32) aus einem oberen Rangbereich (42a) und aus einem unteren Rangbereich (42b) besteht; die beiden gegenüber gebildeten lateralen Seiten des Fahrwerks (32) mit einer ersten Laufschienenmontage (34) bzw. einer zweiten Laufschienenmontage (36) an einem Gestell (30) montiert sind; jede Laufschienenmontage (34, 36) eine feste Schiene (180, 202) und eine bewegliche Schiene (35, 37), die der Länge nach in Bezug auf die feste Schiene (180, 202) verschiebbar sind, aufweist; die beiden gegenüber gebildeten lateralen Seiten des Fahrwerks (32) je an die beweglichen Schienen (35, 37) der Laufschienenmontagen (34, 36) montiert sind; die Position des ersten Armglieds (56) und des zweiten Armglieds (58) des ersten Kabelaufwickelmechanismus' (48) generell mit dem oberen Rangbereich (42a) des Fahrwerks (32) in Übereinstimmung ist, während die Position des ersten Armglieds (76) und des zweiten Armglieds (78) des zweiten Kabelaufwickelmechanismus' (52) generell mit dem unteren Rangbereich (42b) des Fahrwerks (32) in Übereinstimmung ist; die erste Verbindungsvorrichtung (60) des ersten Kabelaufwickelmechanismus' (48) lösbar an der festen Schiene (180) der ersten Laufschienenmontage (34) und die zweite Verbindungsvorrichtung (64) des ersten Kabelaufwickelmechanismus' (48) lösbar am Fahrwerk (32) montiert sind; die erste Verbindungsvorrichtung (80) des zweiten Kabelaufwickelmechanismus' (52) lösbar an der festen Schiene (202) der zweiten Laufschienenmontage (36) und die zweite Verbindungsvorrichtung (84) des zweiten Kabelaufwickelmechanismus (52) lösbar am Fahrwerk (32) montiert sind.

3. Der Kabelaufwickelarm (38) nach Anspruch 1 or 2, worin die Stützklammer (62) des ersten Kabelaufwickelmechanismus' (48) an die erste Verbindungsvorrichtung (60) des ersten Kabelaufwickelmechanismus' (48) angrenzt und unter dieser montiert ist, so dass der zweite Kabelaufwickelmechanismus (52) unter dem ersten Kabelaufwickelmechanismus (48) angeordnet ist, wobei das Verbindungselement (92) des zweiten Stützmechanismus' (54) an der Stützklammer (62) des ersten Kabelaufwickelmechanismus' (48) montiert ist; die Stützklammer (82) des zweiten Kabelaufwickelmechanismus' (52) an die erste Verbindungsvorrichtung (80) des zweiten Kabelaufwickelmechanismus' (52) angrenzt und über dieser montiert ist, so dass der erste Kabelaufwickelmechanismus (48) über dem zweiten Kabelaufwickelmechanismus (52) angeordnet ist, wobei das Verbindungselement (72) des ersten Stützmechanismus' (50) an der Stützklammer (82) des zweiten Kabelaufwickelmechanismus' (52) montiert ist.

4. Der Kabelaufwickelarm (38) nach Anspruch 2, worin die beiden gegenüber liegenden lateralen Seiten des Fahrwerks (32) an einer ersten Anschlussbasis (44) bzw. an einer zweiten Anschlussbasis (46) befestigt sind; jede dieser Anschlussbasen (44, 46) mit einem Anschlagteil (188) gebildet sind; jede der zweiten Verbindungsvorrichtungen (64) des ersten Kabelaufwickelmechanismus' (48) und die zweite Verbindungsvorrichtung (84) des zweiten Kabelaufwickelmechanismus' (52) weiter einen elastischen Teil (150), einen Einrückteil (146), der mit dem Anschlagteil (188) einer entsprechenden Anschlussbasis (44, 46) als Reaktion auf eine elastische Kraft, die mit dem elastischen Teil (150) erzeugt wird, in Eingriff gebracht werden kann, und einen Auslöseteil (148) zum Ausrücken des Einrückteils (146) aus dem Anschlagteil (188) der entsprechenden Anschlussbasis (44, 46) aufweisen.

5. Der Kabelaufwickelarm (38) nach Anspruch 4, worin jede Anschlussbasis (44, 46) weiter eine Einführöffnung (190) und eine Anschlagwand (192) aufweist; jede der zweiten Verbindungsvorrichtungen (64) des ersten Kabelaufwickelmechanismus' (48) und die zweite Verbindungsvorrichtung (84) des zweiten Kabelaufwickelmechanismus' (52) weiter einen Einführteil (142), der in die Einführöffnung (190) eingeführt werden kann und an die Anschlagwand (192) der entsprechenden Anschlussbasis (44, 46) anschlägt, aufweisen.

6. Der Kabelaufwickelarm (38) nach Anspruch 2, worin die feste Schiene (180, 202) einer jeden Laufschienenmontage (34, 36) ein Verbindungsloch (182) aufweisen und jede der ersten Verbindungsvorrichtungen (60) des ersten Kabelaufwickelmechanismus' (48) und die erste Verbindungsvorrichtung (80) des zweiten Kabelaufwickelmechanismus' (52) weiter mit einem elastischen Teil (128) gebildet sind; ein Einrückteil (124) mit dem Verbindungsloch (182) einer entsprechenden festen Schiene (180, 202) als Reaktion auf eine elastische Kraft, die mit dem elastischen Teil (128) erzeugt wird, in Eingriff gebracht werden kann; mit einem Auslöseteil (126) der Einrückteil (124) aus dem Verbindungsloch (182) der entsprechenden festen Schiene (180, 202) ausgerückt wird.

7. Der Kabelaufwickelarm (38) nach Anspruch 6, worin die feste Schiene (180, 202) einer jeden Laufschienenmontage (34, 36) weiter ein Paar befestigender Elemente (184), die je einen Kanal (186) bilden, aufweist; jede der ersten Verbindungsvorrichtungen (60) des ersten Kabelaufwickelmechanismus' (48) und die erste Verbindungsvorrichtung (80) des zweiten Kabelaufwickelmechanismus' (52) weiter mit einem Einführteil (118), der in den Kanal (186) eingeführt werden kann und an das Paar befestigender Elemente (184) der entsprechenden festen Schiene (180, 202) anschlägt, gebildet sind.

8. Der Kabelaufwickelarm (38) nach Anspruch 6, worin jedes bewegliche Glied (74) des ersten Stützmechanismus' (50) und das bewegliche Glied (94) des zweiten Stützmechanismus' (54) mit einem Betätigungsteil (168) gebildet sind; beim Einziehen der beweglichen Schienen (35, 37) der Laufschienenmontagen (34, 36) in eine eingezogene Position relativ zu den festen Schienen (180, 202) das bewegliche Glied (74) des ersten Stützmechanismus' (50) und das bewegliche Glied (94) des zweiten Stützmechanismus' (54) relativ zur ersten Verbindungsvorrichtung (60) des ersten Kabelaufwickelmechanismus' (48) bzw. relativ zur ersten Verbindungsvorrichtung (80) des zweiten Kabelaufwickelmechanismus' (52) verschoben und daher eingezogen werden; jeder der Einrückteile (124) der ersten Verbindungsvorrichtung (60) des ersten Kabelaufwickelmechanismus' (48) und der Einrückteil der ersten Verbindungsvorrichtung (80) des zweiten Kabelaufwickelmechanismus' (52) aus dem Verbindungsloch (182) der entsprechenden festen Schiene (180, 202) als Reaktion auf ein entsprechendes Betätigungsteil (168), der zum Antreiben eines entsprechenden Auslöseteils (126) betätigt wird, ausgerückt werden.

9. Der Kabelaufwickelarm (38) nach Anspruch 1 oder 2, worin die Stützklammer (62) des ersten Kabelaufwickelmechanismus' (48) ein Positionierloch (130) und ein Positionierglied (134), das elastisch an der Stützklammer (62) des ersten Kabelaufwickelmechanismus' (48) befestigt und mit einem Sperrteil (136) in Übereinstimmung mit dem Positionierloch (130) gebildet ist, aufweist; die Stützklammer (82) des zweiten Kabelaufwickelmechanismus' (52) ein Positionierloch und ein Positionierglied, das elastisch an der Stützklammer (82) des zweiten Kabelaufwickelmechanismus' (52) befestigt und mit einem Sperrteil in Übereinstimmung mit dem Positionierloch gebildet ist, aufweist; das Verbindungselement (72) des ersten Stützmechanismus' (50) am Positionierloch der Stützklammer (82) des zweiten Kabelaufwickelmechanismus' (52) montiert ist und mit dem Sperrteil des Positionierglieds des zweiten Kabelaufwickelmechanismus' (52) blockiert wird; das Verbindungselement (92) des zweiten Stützmechanismus' (54) am Positionierloch (130) der Stützklammer (62) des ersten Kabelaufwickelmechanismus' (48) montiert ist und mit dem Sperrteil (136) des Positionierglieds (134) des ersten Kabelaufwickelmechanismus' (48) blockiert wird.

10. Der Kabelaufwickelarm (38) nach Anspruch 1 oder 2, worin jeder erste Kabelaufwickelmechanismus (48) und zweite Kabelaufwickelmechanismus (52) weiter mit einem Schieber (66, 86) gebildet sind; der Schieber (66) des ersten Kabelaufwickelmechanismus' (48) drehgelenkig am ersten Armglied (56) des ersten Kabelaufwickelmechanismus' (48) und beweglich an der ersten Tragschiene (68) des ersten Stützmechanismus' (50) montiert ist; der Schieber (86) des zweiten Kabelaufwickelmechanismus' (52) drehgelenkig am ersten Armglied (76) des zweiten Kabelaufwickelmechanismus' (52) und beweglich an der ersten Tragschiene (88) des zweiten Stützmechanismus' (54) montiert ist.

11. Der Kabelaufwickelarm (38) nach Anspruch 10, worin jede erste Tragschiene (68) des ersten Stützmechanismus' (50) und erste Tragschiene (88) des zweiten Stützmechanismus' (54) mit einem ersten Teil (69a) mit einem positionsbegrenzenden Element (71a) und mit einem zweiten Teil (69b) mit einem positionsbegrenzenden Element (71b) gebildet sind, so dass der Schieber (66) des ersten Kabelaufwickelmechanismus' (48) und der Schieber (86) des zweiten Kabelaufwickelmechanismus' (52) je zwischen einem entsprechenden ersten Teil und einem entsprechenden zweiten Teil mit den entsprechenden positionsbegrenzenden Elementen eingegrenzt sind, wenn die Schieber (66, 86) der ersten Tragschiene (68) des ersten Stützmechanismus' (50) bzw. der ersten Tragschiene (88) des zweiten Stützmechanismus' (54) entlang verschoben werden.

12. Der Kabelaufwickelarm (38) nach Anspruch 1 oder 2, worin das Verbindungselement (72) des ersten Stützmechanismus' (50) an der zweiten Tragschiene (70) des ersten Stützmechanismus' (50) in einer Position angrenzend an einem Endteil der zweiten Tragschiene (70) des ersten Stützmechanismus' (50) befestigt ist.

13. Der Kabelaufwickelarm (38) nach Anspruch 1 oder 2, worin das Verbindungselement (92) des zweiten Stützmechanismus' (54) an der zweiten Tragschiene (90) des zweiten Stützmechanismus' (54) in einer Position angrenzend an einem Endteil der zweiten zweite Tragschiene (90) des zweiten Stützmechanismus' (54) befestigt sind.

14. Der Kabelaufwickelarm (38) nach Anspruch 1, worin die erste Verbindungsvorrichtung (60) des ersten Kabelaufwickelmechanismus' (48) mindestens ein Einrückloch (120) aufweist und mit einem Einrückglied (122) gebildet ist; das Einrückglied (122) mit einem elastischen Teil (128) gebildet ist; mindestens ein Einrückteil (124) mit dem mindestens einen Einrückloch (120) als Reaktion auf eine elastische Kraft, die mit dem elastischen Teil (128) erzeugt wird, in Eingriff gebracht werden kann; ein Auslöseteil (126) zum Ausrücken des mindestens einen Einrückteils (124) aus dem mindestens einen Einrückloch (120); das bewegliche Glied (74) mit einem Betätigungsteil (168) gebildet ist und relativ zur ersten Verbindungsvorrichtung (60) des ersten Kabelaufwickelmechanismus' (48) verschoben werden kann; nach dem Verschieben des beweglichen Glieds (74) in eine eingezogene Position relativ zur ersten Verbindungsvorrichtung (60) des ersten Kabelaufwickelmechanismus' (48) der mindestens eine Einrückteil (124) des Einrückglieds (122) aus dem mindestens einen Einrückloch (120) der ersten Verbindungsvorrichtung (60) des ersten Kabelaufwickelmechanismus' (48) als Reaktion auf den Betätigungsteil (168), der zum Antreiben des Auslöseteils (126) betätigt wird, ausgerückt werden kann.

## Revendications

1. Bras de gestion de câbles (38), **caractérisé par le fait qu'**il comprend :
un premier mécanisme de gestion de câbles (48) **caractérisé par le fait qu'**il comprend : un premier élément de bras (56) ; un second élément de bras (58) raccordé de manière mobile au premier élément de bras (56) ; un premier élément de raccordement (60) raccordé de manière mobile au premier élément de bras (56) et un second élément de raccordement (64) raccordé de manière mobile au second élément de bras (58) ;
un second mécanisme de gestion de câbles (52) **caractérisé par le fait qu'**il comprend : un premier élément de bras (76) ; un second élément de bras (78) raccordé de manière mobile au premier élément de bras (76) ; un premier élément de raccordement (80) raccordé de manière mobile au premier élément de bras (76), et un second élément de raccordement (84) raccordé de manière mobile au second élément de bras (78) ;
**caractérisé en ce que**
le premier élément de raccordement (60) du premier mécanisme de gestion de câbles (48) est **caractérisé par le fait qu'**il comprend en outre une première section de raccordement (106), une seconde section de raccordement (108), et un passage (112) sur la première section de raccordement (106) ;
le premier mécanisme de gestion de câbles (48) est **caractérisé par le fait qu'**il comprend en outre un élément de support (62) raccordé à la seconde section de raccordement (108) ;
le premier élément de raccordement (80) du second mécanisme de gestion de câbles (52) est **caractérisé par le fait qu'**il comprend en outre une extension (196) ;
le bras de gestion de câbles (38) est **caractérisé par le fait qu'**il comprend en outre un premier mécanisme de support (50) et un second mécanisme de support (54),
le premier mécanisme de support (50) **caractérisé par le fait qu'**il comprend : un premier rail de support (68) pour supporter soit le premier élément de bras (56) soit le second élément de bras (58) du premier mécanisme de gestion de câbles (48) ; un second rail de support (70) raccordé de manière télescopique au premier rail de support (68) ; un élément mobile (74) raccordé au premier rail de support (68), l'élément mobile (74) étant monté de manière mobile sur le passage (112) du premier élément de raccordement (60) du premier mécanisme de gestion de câbles (48) ; et un élément de fixation (72) raccordé au second rail de support (70) ;
le second mécanisme de support (54) **caractérisé par le fait qu'**il comprend : un premier rail de support (88) pour supporter soit le premier élément de bras (76) soit le second élément de bras (78) du second mécanisme de gestion de câbles (52) ; un second rail de support (90) raccordé de manière télescopique au premier rail de support (88) ; un élément mobile (94) raccordé au premier rail de support (88), l'élément mobile (94) étant monté de manière mobile sur le premier élément de raccordement (80) du second mécanisme de gestion de câbles (52) ; et un élément de fixation (92) raccordé au second rail de support (90), l'élément de fixation (92) étant monté de manière amovible sur l'élément de support (62) du premier mécanisme de gestion de câbles (48) ; et
le second mécanisme de gestion de câbles (52) **caractérisé par le fait qu'**il comprend en outre un élément de support (82) raccordé à l'extension (196), l'élément de support (82) étant raccordé de manière amovible à l'élément de fixation (72) du premier mécanisme de support (50).

2. Bras de gestion de câbles (38) selon la revendication 1, **caractérisé par le fait que** le bras de gestion de câbles (38) est applicable à un châssis (32), le châssis (32) comprenant une partie supérieure (42a) et une partie inférieure (42b), le châssis (32) comportant deux côtés latéraux opposés montés sur un rack (30) via un premier ensemble de glissières (34) et un second ensemble de glissières (36) respectivement, chacun desdits ensembles de glissières (34, 36) comprenant un rail fixe (180, 202) et un rail mobile (35, 37) déplaçable de manière longitudinale par rapport au rail fixe (180, 202), les deux côtés latéraux opposés du châssis (32) étant montés sur les rails mobiles (35, 37) des ensembles de glissières (34, 36) respectivement ; **caractérisé par le fait que** le premier élément de bras (56) et le second élément de bras (58) du premier mécanisme de gestion de câbles (48) correspondent de manière générale en position à la partie supérieure (42a) du châssis (32), alors que le premier élément de bras (76) et le second élément de bras (78) du second mécanisme de gestion de câbles (52) correspondent de manière générale en position à la partie inférieure (42b) du châssis (32) ; et **caractérisé par le fait que** le premier élément de raccordement (60) du premier mécanisme de gestion de câbles (48) est monté de manière amovible sur le rail fixe (180) du premier ensemble de glissières (34), que le second élément de raccordement (64) du premier mécanisme de gestion de câbles (48) est monté de manière amovible sur le châssis (32), que le premier élément de raccordement (80) du second mécanisme de gestion de câbles (52) est monté de manière amovible sur le rail fixe (202) du second ensemble de glissières (36), et que le second élément de raccordement (84) du second mécanisme de gestion de câbles (52) est monté de manière amovible sur le châssis (32).

3. Bras de gestion de câbles (38) selon la revendication 1 ou 2, **caractérisé par le fait que** l'élément de support (62) du premier mécanisme de gestion de câbles (48) est adjacent à et sous le premier élément de raccordement (60) du premier mécanisme de gestion de câbles (48) de sorte que, avec l'élément de fixation (92) du second mécanisme de support (54) monté sur l'élément de support (62) du premier mécanisme de gestion de câbles (48), le second mécanisme de gestion de câbles (52) se situe sous le premier mécanisme de gestion de câbles (48) ; et **caractérisé par le fait que** l'élément de support (82) du second mécanisme de gestion de câbles (52) est adjacent à et au-dessus du premier élément de raccordement (80) du second mécanisme de gestion de câbles (52) de sorte que, avec l'élément de fixation (72) du premier mécanisme de support (50) monté sur l'élément de support (82) du second mécanisme de gestion de câbles (52), le premier mécanisme de gestion de câbles (48) se situe au-dessus du second mécanisme de gestion de câbles (52).

4. Bras de gestion de câbles (38) selon la revendication 2, **caractérisé par le fait que** les deux côtés latéraux opposés du châssis (32) sont respectivement raccordés à une première base de raccordement (44) et à une seconde base de raccordement (46), chaque dite base de raccordement (44, 46) comprend une partie d'arrêt (188), et chacun des second élément de raccordement (64) du premier mécanisme de gestion de câbles (48) et second élément de raccordement (84) du second mécanisme de gestion de câbles (52) **caractérisé par le fait qu'**il comprend en outre une partie élastique (150), une partie d'engagement (146) pouvant s'engager avec la partie d'arrêt (188) d'une dite base de raccordement correspondante (44, 46) en réponse à une force élastique fournie par la partie élastique (150), et une partie de désengagement (148) pour désengager la partie d'engagement (146) de la partie d'arrêt (188) de la base de raccordement correspondante (44, 46).

5. Bras de gestion de câbles (38) selon la revendication 4, **caractérisé par le fait que** chaque dite base de raccordement (44, 46) comprend en outre une ouverture d'insertion (190) et une paroi d'arrêt (192), et chacun des second élément de raccordement (64) du premier mécanisme de gestion de câbles (48) et second élément de raccordement (84) du second mécanisme de gestion de câbles (52) comprend en outre une partie d'insertion (142) insérable dans l'ouverture d'insertion (190), et pouvant être arrêtée grâce à la paroi d'arrêt (192), de la base de raccordement correspondante (44, 46).

6. Bras de gestion de câbles (38) selon la revendication 2, **caractérisé par le fait que** le rail fixe (180, 202) de chacun desdits ensembles de glissières (34, 36) comprend un trou de raccordement (182), et chacun des premier élément de raccordement (60) du premier mécanisme de gestion de câbles (48) et premier élément de raccordement (80) du second mécanisme de gestion de câbles (52) comprend en outre une partie élastique (128), une partie d'engagement (124) pouvant s'engager avec le trou de raccordement (182) d'un dit rail fixe (180, 202) correspondant en réponse à une force élastique fournie par la partie élastique (128), et une partie de désengagement (126) pour désengager la partie d'engagement (124) du trou de raccordement (182) du rail fixe correspondant (180, 202).

7. Bras de gestion de câbles (38) selon la revendication 6, **caractérisé par le fait que** le rail fixe (180, 202) de chacun desdits ensembles de glissières (34, 36) comprend en outre une paire d'éléments de fixation (184) qui définit une gorge (186), et chacun des premier élément de raccordement (60) du premier mécanisme de gestion de câbles (48) et premier élément de raccordement (80) du second mécanisme de gestion de câbles (52) comprend en outre une partie d'insertion (118) insérable dans la gorge (186), et pouvant être arrêtée grâce à la paire d'éléments de fixation (184), du rail fixe correspondant (180, 202).

8. Bras de gestion de câbles (38) selon la revendication 6, **caractérisé par le fait que** chacun des élément mobile (74) du premier mécanisme de support (50) et élément mobile (94) du second mécanisme de support (54) comprend une partie d'actionnement (168) ; lorsque les rails mobiles (35, 37) des ensembles de glissières (34, 36) sont rétractés sur une position rétractée par rapport aux rails fixes (180, 202), l'élément mobile (74) du premier mécanisme de support (50) et l'élément mobile (94) du second mécanisme de support (54) sont déplacés par rapport au premier élément de raccordement (60) du premier mécanisme de gestion de câbles (48) et au premier élément de raccordement (80) du second mécanisme de gestion de câbles (52) respectivement et sont ainsi rétractés ; et chacune des partie d'engagement (124) du premier élément de raccordement (60) du premier mécanisme de gestion de câbles (48) et partie d'engagement du premier élément de raccordement (80) du second mécanisme de gestion de câbles (52) peut être désengagée du trou de raccordement (182) du rail fixe correspondant (180, 202) en réponse à une dite partie d'actionnement (168) correspondante étant actionnée pour entraîner une dite partie de désengagement correspondante (126).

9. Bras de gestion de câbles (38) selon la revendication 1 ou 2, **caractérisé par le fait que** l'élément de support (62) du premier mécanisme de gestion de câbles (48) comprend un trou de positionnement (130) et un élément de positionnement (134) raccordé de manière élastique à l'élément de support (62) du premier mécanisme de gestion de câbles (48) et comportant une partie de blocage (136) correspondant au trou de positionnement (130), et l'élément de support (82) du second mécanisme de gestion de câbles (52) comprend un trou de positionnement et un élément de positionnement raccordé de manière élastique à l'élément de support (82) du second mécanisme de gestion de câbles (52) et comportant une partie de blocage correspondant au trou de positionnement ; l'élément de fixation (72) du premier mécanisme de support (50) est monté sur le trou de positionnement de l'élément de support (82) du second mécanisme de gestion de câbles (52) et est bloqué par la partie de blocage (136) de l'élément de positionnement du second mécanisme de gestion de câbles (52), et l'élément de fixation (92) du second mécanisme de support (54) est monté sur le trou de positionnement (130) de l'élément de support (62) du premier mécanisme de gestion de câbles (48) et est bloqué par la partie de blocage (136) de l'élément de positionnement (134) du premier mécanisme de gestion de câbles (48).

10. Bras de gestion de câbles (38) selon la revendication 1 ou 2, **caractérisé par le fait que** chacun des premier mécanisme de gestion de câbles (48) et second mécanisme de gestion de câbles (52) comprend en outre un élément coulissant (66, 86), l'élément coulissant (66) du premier mécanisme de gestion de câbles (48) est raccordé de manière pivotante au premier élément de bras (56) du premier mécanisme de gestion de câbles (48) et est raccordé de manière mobile au premier rail de support (68) du premier mécanisme de support (50), et l'élément coulissant (86) du second mécanisme de gestion de câbles (52) est raccordé de manière pivotante au premier élément de bras (76) du second mécanisme de gestion de câbles (52) et est raccordé de manière mobile au premier rail de support (88) du second mécanisme de support (54).

11. Bras de gestion de câbles (38) selon la revendication 10, **caractérisé par le fait que** chacun des premier rail de support (68) du premier mécanisme de support (50) et premier rail de support (88) du second mécanisme de support (54) comprend une première partie (69a) avec un élément de restriction de position (71a) et une seconde partie (69b) avec un élément de restriction de position (71b) de sorte que, lorsque déplacé le long du premier rail de support (68) du premier mécanisme de support (50) et du premier rail de support (88) du second mécanisme de support (54) respectivement, l'élément coulissant (66) du premier mécanisme de gestion de câbles (48) et l'élément coulissant (86) du second mécanisme de gestion de câbles (52) sont chacun restreint entre une dite première partie correspondante et une dite seconde partie correspondante par lesdits éléments de restriction de position correspondants.

12. Bras de gestion de câbles (38) selon la revendication 1 ou 2, **caractérisé par le fait que** l'élément de fixation (72) du premier mécanisme de support (50) est raccordé au second rail de support (70) du premier mécanisme de support (50) à une position adjacente à une partie terminale du second rail de support (70) du premier mécanisme de support (50).

13. Bras de gestion de câbles (38) selon la revendication 1 ou 2, **caractérisé par le fait que** l'élément de fixation (92) du second mécanisme de support (54) est raccordé au second rail de support (90) du second mécanisme de support (54) à une position adjacente à une partie terminale du second rail de support (90) du second mécanisme de support (54).

14. Bras de gestion de câbles (38) selon la revendication 1, **caractérisé par le fait que** le premier élément de raccordement (60) du premier mécanisme de gestion de câbles (48) comprend au moins un trou d'engagement (120) et un élément d'engagement (122) ; l'élément d'engagement (122) comporte une partie élastique (128), au moins une partie d'engagement (124) pouvant s'engager avec le ou les trous d'engagement (120) en réponse à une force élastique fournie par la partie élastique (128), et une partie de désengagement (126) pour désengager la ou les parties d'engagement (124) du ou des trous d'engagement (120) ; l'élément mobile (74) comprend une partie d'actionnement (168) et est déplaçable par rapport au premier élément de raccordement (60) du premier mécanisme de gestion de câbles (48) ; lorsque l'élément mobile (74) a été déplacé vers une position rétractée par rapport au premier élément de raccordement (60) du premier mécanisme de gestion de câbles (48), la ou les parties d'engagement (124) de l'élément d'engagement (122) peut être désengagée du ou des trous d'engagement (120) du premier élément de raccordement (60) du premier mécanisme de gestion de câbles (48) en réponse à la partie d'actionnement (168) étant actionnée pour entraîner la partie de désengagement (126).
